# EUROPÄISCHE PATENTSCHRIFT

(11) **EP 2 712 000 B1**
(45) Veröffentlichungstag und Bekanntmachung des Hinweises auf die Patenterteilung: **15.02.2017**
(21) Anmeldenummer: 13005843.1
(22) Anmeldetag: 25.08.2009
(51) Int. Cl.: H01L 51/54, C07F 1/08

(54) **Materialien für organische Elektrolumineszenzvorrichtungen**
Materials for Organic Electroluminescent Devices
Matériaux pour des Dispositifs Électroluminescents Organiques

(30) Priorität: 22.09.2008 DE 102008048336
(43) Veröffentlichungstag der Anmeldung: 26.03.2014
(62) Teilanmeldung aus: 09778094.4
(73) Patentinhaber: Merck Patent GmbH, 64293 Darmstadt (DE)
(72) Erfinder: Yersin, Hartmut, 93161 Sinzing (DE); Monkowius, Uwe, 4020 Linz (AT); Czerwieniec, Rafal, 93083 Obertraubling (DE); Yu, Jiangbo, Clemsen, SC 29631 (US)

(56) Entgegenhaltungen:
- WO-A-2008/087031
- WO-A-2009/003700
- MARZANO C; PELLEI M; ALIDORI S; BROSSA A; LOBBIA G G; TISATO F; SANTINI C: "New copper(I) phosphane complexes of dihydridobis(3-nitro-1,2,4-triazolyl)borat e ligand showing cytotoxic activity", JOURNAL OF INORGANIC BIOCHEMISTRY, ELSEVIER, US, Bd. 100, Nr. 2, 1. Februar 2006 (2006-02-01), Seiten 299-304, XP025038348, ISSN: 0162-0134 [gefunden am 2006-02-01]
- GIANCARLO GIOIA LOBBIA; ET AL: "Copper(I) coordination polymers and mononuclear copper(I) complexes built from poly(1,2,4-triazolyl)borate ligands and tri-organophosphines", JOURNAL OF THE CHEMICAL SOCIETY, DALTON TRANSACTIONS, CHEMICAL SOCIETY. LETCHWORTH, GB, 1. Januar 2002 (2002-01-01), Seiten 2333-2340, XP007910004, ISSN: 1472-7773
- DOU J; ET AL: "Synthesis and Structure of 3 Carborane Complexes", EUROPEAN JOURNAL OF INORGANIC CHEMISTRY, WILEY-VCH VERLAG, WEINHEIM, DE, Nr. 1, 1. Januar 2007 (2007-01-01), Seiten 53-59, XP002501595, ISSN: 1434-1948
- MARZANO C; ET AL: "Synthesis, Characterization, and in Vitro Antitumor Properties of Tris(hydroxymethyl)phosphine Copper(I) Complexes Containing the New Bis(1,2,4-triazol-1-yl)acetate Ligand", JOURNAL OF MEDICINAL CHEMISTRY, AMERICAN CHEMICAL SOCIETY, WASHINGTON, US, Bd. 49, 18. November 2006 (2006-11-18), Seiten 7317-7324, XP007910003, ISSN: 0022-2623
- MONKOWIUS; SVARTSOV U; FISCHER Y N; ZABEL T; YERSIN M; H: "Synthesis, crystal structures, and electronic spectra of (1,8-naphthyridine)Re<I>(CO)3Cl and [(1,8-naphthyridine)Cu<I>(DPEPhos)]PF6", INORGANIC CHEMISTRY COMMUNICATIONS, ELSEVIER, AMSTERDAM, NL, Bd. 10, Nr. 12, 26. Oktober 2007 (2007-10-26), Seiten 1473-1477, XP022356572, ISSN: 1387-7003
- ZHANG Q; ZHOU Q; CHENG Y; WANG L; MA D; JING X; WANG F: "Highly Efficient Green Phosphorescent Organic Light-Emitting Diodes Based on Cu<I> Complexes", ADVANCED MATERIALS 20040305 WILEY-VCH VERLAG DE, Bd. 16, Nr. 5, 5. März 2004 (2004-03-05), Seiten 432-436, XP002359145,
- ARMAROLI N; ACCORSI G; HOLLER M; MOUDAM O; NIERENGARTEN J-F; ZHOU Z; WEGH R T; WELTER R: "Highly luminescent Cu<i> complexes for light-emitting electrochemical cells", ADVANCED MATERIALS 20060515 WILEY-VCH VERLAG DE, Bd. 18, Nr. 10, 15. Mai 2006 (2006-05-15), Seiten 1313-1316, XP007910006,

## Beschreibung

Die Erfindung betrifft eine elektronische Vorrichtung enthaltend einkernige neutrale Kupfer(I)-Komplexe gemäß Formel A ([(N∩N)CuL₂]), 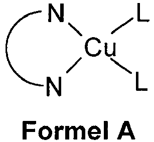 wobei N∩N für einen chelatisierenden N-heterocyclischen Liganden steht, der über zwei Stickstoffatome an das Kupferatom bindet und L unabhängig voneinander ein Phosphan oder Arsan-Ligand ist. Beide Liganden L können auch miteinander verbunden sein, so dass sich ein zweibindiger Ligand ergibt. Dabei müssen entweder a) N∩N einfach negativ und die beiden Liganden (Phosphan- oder Arsanliganden) neutral sein (bevorzugte Ausführungsform) oder b) NnN neutral und die beiden Phosphan/Arsan-Liganden zusammengenommen einfach negativ geladen sein, so dass der einkernige Kupfer(I)-Komplex elektrisch neutral ist.

### Einleitung

Zur Zeit zeichnet sich ein Wandel im Bereich der Bildschirm- und Beleuchtungstechnik ab. Es wird möglich sein, flache Displays oder Leuchtflächen mit einer Dicke von unter 0,5 mm zu fertigen. Diese sind durch viele faszinierende Eigenschaften ausgezeichnet. So werden z. B. Leuchtflächen als Tapeten mit sehr geringem Energieverbrauch realisierbar sein. Besonders interessant ist aber, dass Farbbildschirme mit bisher nicht erreichbarer Farbechtheit, Helligkeit und Blickwinkelunabhängigkeit, mit geringem Gewicht sowie sehr niedrigem Stromverbrauch herstellbar sein werden. Die Bildschirme werden sich als Mikrodisplays oder Großbildschirme mit mehreren m² Fläche in starrer Form oder flexibel, aber auch als Transmissions- oder Reflexions-Displays gestalten lassen. Ferner ist es möglich, einfache und kostensparende Herstellungsverfahren wie Siebdruck, Tintenstrahldruck oder Vakuumsublimation einzusetzen. Dadurch wird im Vergleich zu herkömmlichen Flachbildschirmen eine sehr preiswerte

### Materialien für organische Elektrolumineszenzvorrichtungen

Die Erfindung betrifft einkernige neutrale Kupfer(I)-Komplexe gemäß Formel A ([(N∩N)CuL₂]) sowie deren Verwendung zur Herstellung optoelektronischer Bauelemente, 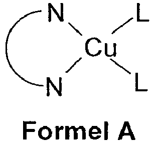 wobei N∩N für einen chelatisierenden N-heterocyclischen Liganden steht, der über zwei Stickstoffatome an das Kupferatom bindet und L unabhängig voneinander ein Phosphan oder Arsan-Ligand ist. Beide Liganden L können auch miteinander verbunden sein, so dass sich ein zweibindiger Ligand ergibt. Dabei müssen entweder a) N∩N einfach negativ und die beiden Liganden (Phosphan- oder Arsanliganden) neutral sein (bevorzugte Ausführungsform) oder b) N∩N neutral und die beiden Phosphan/Arsan-Liganden zusammengenommen einfach negativ geladen sein, so dass der einkernige Kupfer(I)-Komplex elektrisch neutral ist.

### Einleitung

Zur Zeit zeichnet sich ein Wandel im Bereich der Bildschirm- und Beleuchtungstechnik ab. Es wird möglich sein, flache Displays oder Leuchtflächen mit einer Dicke von unter 0,5 mm zu fertigen. Diese sind durch viele faszinierende Eigenschaften ausgezeichnet. So werden z. B. Leuchtflächen als Tapeten mit sehr geringem Energieverbrauch realisierbar sein. Besonders interessant ist aber, dass Farbbildschirme mit bisher nicht erreichbarer Farbechtheit, Helligkeit und Blickwinkelunabhängigkeit, mit geringem Gewicht sowie sehr niedrigem Stromverbrauch herstellbar sein werden. Die Bildschirme werden sich als Mikrodisplays oder Großbildschirme mit mehreren m² Fläche in starrer Form oder flexibel, aber auch als Transmissions- oder Reflexions-Displays gestalten lassen. Ferner ist es möglich, einfache und kostensparende Herstellungsverfahren wie Siebdruck, Tintenstrahldruck oder Vakuumsublimation einzusetzen. Dadurch wird im Vergleich zu herkömmlichen Flachbildschirmen eine sehr preiswerte Fertigung ermöglicht. Diese neue Technik basiert auf dem Prinzip der **OLED**s**,** den **O**rganic **L**ight **E**mitting **D**evices.

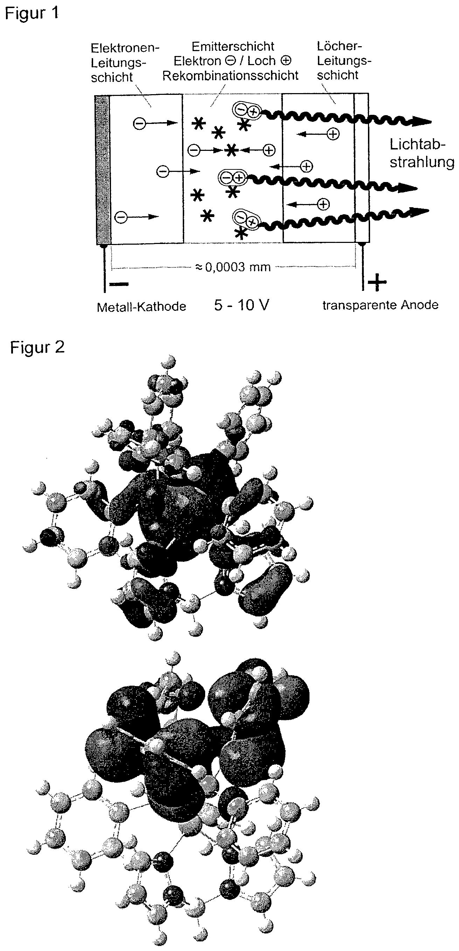

Derartige Bauteile bestehen vorwiegend aus organischen Schichten, wie in Fig. 1 schematisch und vereinfacht gezeigt ist. Bei einer Spannung von z. B. 5 V bis 10 V treten aus einer leitenden Metallschicht, z. B. aus einer Aluminium-Kathode, negative Elektronen in eine dünne Elektronenleitungsschicht und wandern in Richtung der positiven Anode. Diese besteht z. B. aus einer durchsichtigen, elektrisch leitenden, dünnen Indium-Zinn-OxidSchicht, von der positive Ladungsträger ("Löcher"), in eine organische Löcherleitungsschicht einwandern. Diese Löcher bewegen sich im Vergleich zu den Elektronen in entgegengesetzter Richtung, und zwar auf die negative Kathode zu. In einer mittleren Schicht, der Emitterschicht, die ebenfalls aus einem organischen Material besteht, befinden sich zusätzlich besondere Emitter-Moleküle, an denen oder in deren Nähe die beiden Ladungsträger rekombinieren und dabei zu energetisch angeregten Zuständen der Emitter-Moleküle führen. Die angeregten Zustände geben dann ihre Energie als Lichtemission ab. Auf eine separate Emitterschicht kann gegebenenfalls auch verzichtet werden, wenn die Emitter-Moleküle sich in der Loch- oder Elektronen-Leitungsschicht befinden.

Die OLED-Bauelemente lassen sich großflächig als Beleuchtungskörper oder auch äußerst klein als Pixel für Displays gestalten. Entscheidend für den Bau hocheffizienter OLEDs sind die verwendeten Leuchtmaterialien (Emitter-Moleküle). Diese können in verschiedener Weise realisiert werden, und zwar unter Verwendung organischer oder metallorganischer Verbindungen. Es lässt sich zeigen, dass die Lichtausbeute der OLEDs mit metallorganischen Substanzen, den sog. Triplett-Emittern, wesentlich größer sein kann als mit rein organischen Emitter-Materialien. Aufgrund dieser Eigenschaft kommt der Weiterentwicklung der metallorganischen Materialien ein wesentlicher Stellenwert zu. Die Funktion von OLEDs ist bereits sehr häufig beschrieben worden.[i-vi] Unter Einsatz von metallorganischen Komplexen mit hoher Emissionsquantenausbeute lässt sich eine besonders hohe Effizienz des Devices erzielen. Diese Materialien werden häufig als Triplett-Emitter oder phosphoreszierende Emitter bezeichnet. Diese Erkenntnis ist seit längerem bekannt.[i-v] Für Triplett-Emitter wurden bereits viele Schutzrechte beantragt bzw. erteilt.[vii-xix]

Triplett-Emitter weisen ein großes Potential zur Lichterzeugung in Displays (als Pixel) und in Beleuchtungsflächen (z. B. als Leuchttapete) auf. Sehr viele Triplett-Emitter-Materialien wurden bereits patentiert und werden mittlerweile auch technologisch in ersten Devices eingesetzt. Die bisherigen Lösungen weisen Nachteile/Probleme auf, und zwar in folgenden Bereichen:
- Langzeitstabilität der Emitter in den OLED-Devices,
- Thermische Stabilität,
- Chemische Stabilität gegenüber Wasser und Sauerstoff,
- Chemische Variabilität,
- Verfügbarkeit wichtiger Emissionsfarben,
- Fertigungstechnische Reproduzierbarkeit,
- Erreichbarkeit hoher Effizienzen der Umwandlung des elektrischen Stroms in Licht,
- Erreichbarkeit sehr hoher Leuchtdichten bei hoher Effizienz,
- Verwendung preiswerter Emittermaterialien,
- Toxizität der verwendeten Materialien / Entsorgung benutzter Leuchtelemente,
- Realisierung blau emittierender OLEDs.

Metallorganische Triplett-Emitter wurden schon mit Erfolg als Emitter-Materialien in OLEDs eingesetzt. Insbesondere konnten sehr effiziente OLEDs mit rot und grün lumineszierenden Triplett-Emittern konstruiert werden. Allerdings stößt die Herstellung von blau emittierenden OLEDs immer noch auf erhebliche Schwierigkeiten. Neben dem Mangel geeigneter Matrixmaterialien für die Emitter, geeigneter loch- und/oder elektronenleitender Matrix-Materialien, besteht eine der Hauptschwierigkeiten darin, dass die Zahl der bisher bekannten und verwendbaren Triplettemitter sehr begrenzt ist. Da für die blau lumineszierenden Triplett-Emitter der Energieabstand zwischen dem untersten Triplettzustand und dem Grundzustand sehr groß ist, wird die Emission oft durch thermische Besetzung nicht emittierender, angeregter Zustände, insbesondere der metallzentrierten dd* Zustände, intramolekular gelöscht. In den bisherigen Eine Alternative für derartige metallorganische Verbindungen der PlatinGruppe kann die Verwendung von metallorganischen Komplexen anderer, billigerer Übergangsmetalle sein, insbesondere von Kupfer. Lumineszierende Kupfer(I)-Komplexe sind schon seit langem bekannt, z. B. Kupfer(I)-Komplexe mit aromatischen Diimin-Liganden (z. B. 1,10-Phenanthroline) weisen eine intensive rote Photolumineszenz auf.[xx] Ebenso ist eine große Zahl zwei- und mehrkerniger Kupfer(I)-Komplexe mit N-heteroaromatischen [xxi] und/oder Phosphanliganden [xxii,xxiii,xxiv] beschrieben worden, die intensiv lumineszieren.

Einige Kupfer(I)-Komplexe wurden schon als OLED-Emittermaterialien vorgeschlagen:
Monkovius et al., Inorganic Chemistry Communications, Bd. 10, Nr. 12, 2007, 1473-1477, Elsevier, Amsterdam, NL;
Zhang et al., Advanced Materials, Bd. 16, Nr. 5, 2004, 432-436, Wiley-VCH Verlag DE;
und Armaroli et al., Advanced Materials, Bd. 18, Nr. 10, 2006, 1313-1316, Wiley-VCH Verlag DE.

Außerdem beschreibt JP 2006/228936 (I. Toshihiro) die Anwendung von zwei- und drei-kernigen Cu-, Ag-, Hg- und Pt-Komplexen mit stickstoffhaltigen heteroaromatischen Liganden, insbesondere mit substituierten Pyrazolen. In WO 2006/032449 A1 (A. Vogler et al.) wurde die Verwendung von einkernigen Kupfer(I)-Komplexen mit einem dreizähnigen Trisphosphan- und einem kleinen, anionischen Liganden (z. B. Halogen, CN⁻, SCN⁻, usw.) beschrieben. Anders als postuliert [xxv], handelt es sich hier jedoch höchstwahrscheinlich um einen zweikernigen Komplex. [xxvi] Elektrolumineszierende Kupfer(I)-Komplexe mit Düminliganden (z. B. 1,10-Phenanthrolin) wurden in US 2005/0221115 A1 (A. Tsuboyama et al.) vorgeschlagen, sowie organische Polymere, an die derartige Komplexe angehängt sind. Verschiedene Kupfer(I)-Diimin-Komplexe sowie Kupfer-Cluster [xxvii] als grüne und rote Triplett-Emitter in OLEDs und LECs [xxviii] (licht-emittierende elektrochemische Zellen) wurden ebenfalls beschrieben. [xxix] Zweikernige Cu-Komplexe mit verbrückenden, zweizähnigen Liganden sind in WO 2005/054404 A1 (A. Tsuboyama et al.) beschrieben.

### Beschreibung der Erfindung

Die vorliegende Erfindung betrifft eine elektronische Vorrichtung enthaltend einkernige neutrale Kupfer(I)-Komplexe der Formel A,

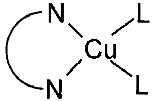

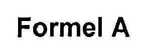

In Formel A (nachfolgend auch als [(N∩N)CuL₂] bezeichnet) steht N∩N für einen chelatisierenden N-heterocyclischen Liganden, der über zwei Stickstoffatome an das Kupferzentrum bindet und L unabhängig voneinander für einen Phosphan oder Arsan-Liganden, wobei beide Liganden L auch miteinander verbunden sein können, so dass sich ein zweibindiger Ligand ergibt, oder wobei ein Ligand L bzw. beide Liganden L auch mit N∩N verbunden sein können, so dass sich ein dreibindiger oder vierbindiger Ligand ergibt. Dabei müssen entweder
a) NnN einfach negativ und die beiden Liganden L (Phosphan- und/oder Arsanligand) neutral sein (bevorzugte Ausführungsform) oder
b) NnN neutral und die beiden Liganden L (Phosphan- und/oder Arsanligand) zusammengenommen einfach negativ geladen sein, so dass der Kupfer(I)komplex der Formel A insgesamt elektrisch neutral ist.

Spezielle Ausführungsformen der erfindungsgemäßen einkernigen, neutralen Kupfer(I)-Komplexe der Formel A werden durch die Verbindungen der Formeln III bis V dargestellt und im Folgenden erläutert.

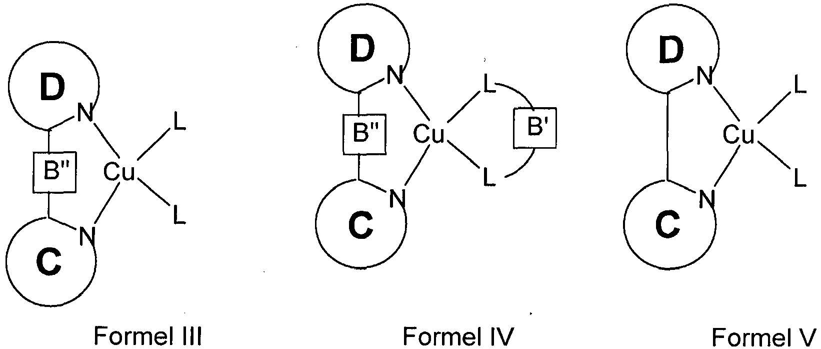

Die Bedeutung der in den Formeln III bis V verwendeten Symbole und Indizes wird unten erläutert.

Viele der bisher vorgestellten Kupferkomplexe haben meist den Nachteil, dass sie nicht neutral, sondern geladen sind. Dies führt z. T. zu Problemen bei der Herstellung und dem Betrieb der üblichen optoelektronischen Bauteile. Beispielsweise verhindert die fehlende Flüchtigkeit geladener Komplexe die Aufbringung durch Vakuumsublimation, und im Betrieb eines üblichen OLEDs könnten geladene Emitter aufgrund der hohen elektrischen Feldstärken zu unerwünschten Ionenwanderungen führen.

Die Neutralität der Kupfer(I)-Komplexe der Formel III bis V wird gewährleistet, da Cu(I) einfach positiv und einer der Liganden einfach negativ geladen ist. Die erfindungsgemäßen einkernigen neutralen Kupfer(I)-Komplexe weisen demgemäß einen einfach negativ geladenen Liganden und einen neutralen Liganden auf.

Damit die Komplexe als blaue Triplett-Emitter für OLEDs geeignet sind, müssen deren **S₀-T₁** Energieabstände ausreichend groß sein (**S₀** = elektronischer Grundzustand, **T₁** = tiefster angeregter Triplett-Zustand). Die energetischen Abstände sollten größer als 22 000 cm⁻¹, bevorzugt größer als 25 000 cm⁻¹ sein. Dieses Erfordernis wird von den Komplexen der vorliegenden Erfindung erfüllt. Komplexe mit einem kleineren **S₀-T₁** Energieabstand eignen sich auch für grüne oder rote Emission.

### Anionische Liganden N-B"-N und neutrale Liganden L bzw. L-B'-L (Phosphane und Arsane, ein oder zweibindig)

Die anionischen Liganden der Formeln III bis V sind Stickstoffliganden, die folgenden Formeln aufweisen: 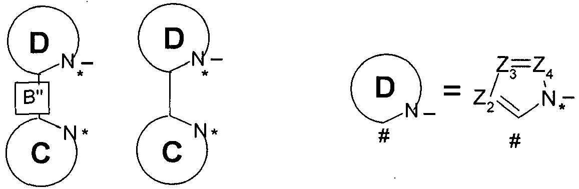 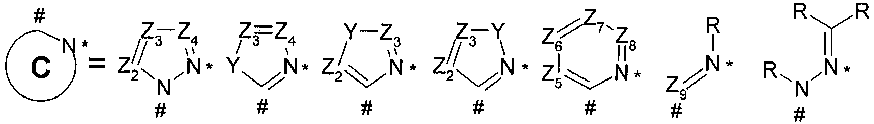 wobei
Z₂-Z₉ ist bei jedem Auftreten gleich oder verschieden N oder CR;
- R: ist bei jedem Auftreten gleich oder verschieden ausgewählt aus der Gruppe bestehend aus H, D, F, Cl, Br, I, CN, NO₂, N(R¹)₂, C(=O)R¹, Si(R¹)₃, einer geradkettigen Alkyl-, Alkoxy- oder Thioalkylgruppe mit 1 bis 40 C-Atomen oder einer verzweigten oder cyclischen Alkyl-, Alkoxy- oder Thioalkylgruppe mit 3 bis 40 C-Atomen oder einer Alkenyl- oder Alkinylgruppe mit 2 bis 40 C-Atomen, die jeweils mit einem oder mehreren Resten R¹ substituiert sein kann, wobei eine oder mehrere nicht-benachbarte CH₂-Gruppen durch R¹C=CR¹, C=C, Si(R¹)₂, Ge(R¹)₂, Sn(R¹)₂, C=O, C=S, C=Se, C=NR¹, P(=O)(R¹), SO, SO₂, NR¹, O, S oder CONR¹ ersetzt sein können und wobei ein oder mehrere H-Atome durch D, F, Cl, Br, I, CN oder NO₂ ersetzt sein können, einem aromatischen oder heteroaromatischen Ringsystem mit 5 bis 60 aromatischen Ringatomen, das jeweils mit einem oder mehreren Resten R¹ substituiert sein kann, einer Aryloxy- oder Heteroaryloxygruppe mit 5 bis 60 aromatischen Ringatomen, die mit einem oder mehreren Resten R¹ substituiert sein kann, oder einer Kombination dieser Systeme, wobei optional zwei oder mehr benachbarte Substituenten R ein monocyclisches oder polycyclisches, aliphatisches, aromatisches oder heteroaromatisches Ringsystem bilden können, das mit einem oder mehreren Resten R¹ substituiert sein kann;
- R¹: ist bei jedem Auftreten gleich oder verschieden ausgewählt aus der Gruppe bestehend aus H, D, F, CN, aliphatischem Kohlenwasserstoffrest mit 1 bis 20 C-Atomen, aromatischem oder heteroaromatischem Ringsystem mit 5 bis 30 aromatischen Ringatomen, in dem ein oder mehrere H-Atome durch D, F, Cl, Br, I oder CN ersetzt sein können, wobei zwei oder mehr benachbarte Substituenten R³ miteinander ein mono- oder polycyclisches, aliphatisches, aromatisches oder heteroaromatisches Ringsystem bilden können;
- Y: ist bei jedem Auftreten gleich oder verschieden O, S oder NR;
- B": ist eine neutrale Brücke, insbesondere ist bei jedem Auftreten gleich oder verschieden eine bivalente Brücke, ausgewählt aus NR, BR, O, CR₂, SiR₂, C=NR, C=CR₂, S, S=O, SO₂, PR und P(=O)R;
"*" das Atom kennzeichnet, das die Komplexbindung eingeht; und "#" das Atom kennzeichnet, das über B mit der zweiten Einheit verbunden ist.

Stickstoffliganden, die die Brücke B" enthalten, sollen im Folgenden als N-B"-N bezeichnet werden, und diejenigen, die die Brücke nicht enthalten, als N∩N.

Folgende Beispiele sollen diese Liganden verdeutlichen:

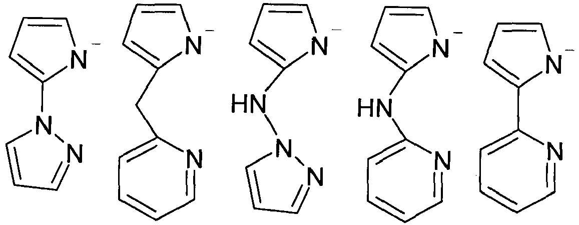

Dabei können diese Strukturen auch durch einen oder mehrere Reste R substituiert sein.

Damit ergeben sich Komplexe der allgemeinen Formeln III bis V: 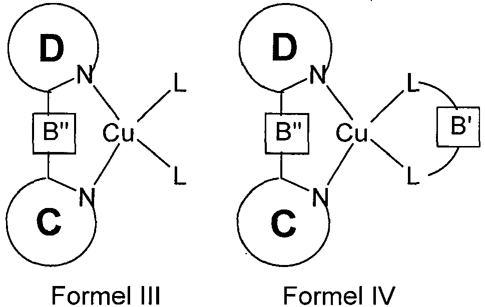 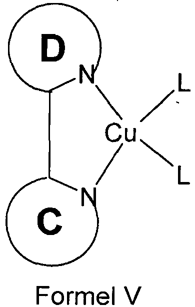 wobei:
- L: ein einzähniger Phosphan- oder Arsan-Ligand R₃E (mit E = P oder As) ist;
- L-B'-L: ein Phosphanyl- oder Arsanyl-Rest (R₂E#, mit E = P oder As) ist, der über eine Brücke B' mit einem weiteren Rest L verbunden ist und damit einen zweizähnigen Liganden bildet; und
- B': eine Alkylen- oder Arylen-Gruppe oder einer Kombination beider, oder -O-, -NR- oder -SiR₂- ist.

In einer bevorzugten Ausführungsform der Erfindung ist E gleich Phosphor.

Folgende Beispiele sollen dies verdeutlichen:

### Beispiele für L:

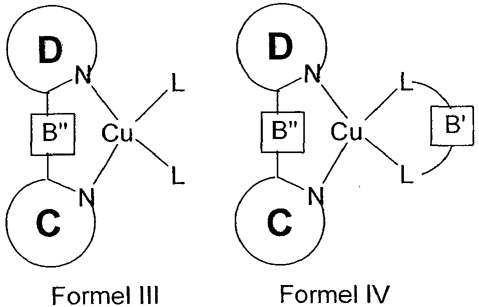

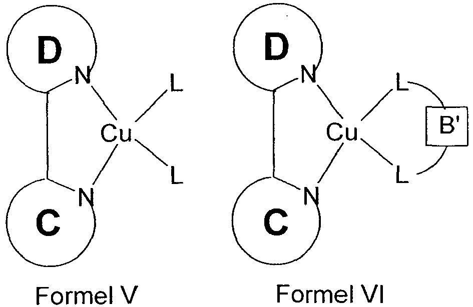

wobei:
- L: ein einzähniger Phosphan- oder Arsan-Ligand R₃E (mit E = P oder As) ist;
- L-B'-L: ein Phosphanyl- oder Arsanyl-Rest (R₂E#, mit E = P oder As) ist, der über eine Brücke B' mit einem weiteren Rest L verbunden ist und damit einen zweizähnigen Liganden bildet; und
- B': eine Alkylen- oder Arylen-Gruppe oder einer Kombination beider, oder -O-, -NR- oder -SiR₂- ist.

In einer bevorzugten Ausführungsform der Erfindung ist E gleich Phosphor.

Folgende Beispiele sollen dies verdeutlichen:

### Beispiele für L:

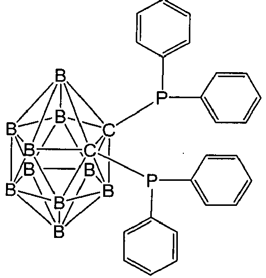

### usw.

Dabei können die Liganden L bzw. L-B'-L auch durch einen oder mehrere Reste R substituiert sein, wobei R die oben genannte Bedeutung hat.

Die oben genannten neutralen und einfach negativ geladenen Stickstoff- und Phosphan-Liganden sind schon aus der Koordinationschemie der Übergangsmetalle bekannt. In US 6649801 B2 (J.C. Peters et al.) und US 5627164 (S. Gorun et al.) wurden einige zwitterionische Übergangsmetall-Komplexe mit borhaltigen Liganden als potentielle Katalysatoren beschrieben. Da die angeregten Zustände der N-heteroaromatischen Gruppen (insbesondere Pyrazolyl-Gruppen) und die der Phosphan- und Arsan-Liganden energetisch sehr hoch liegen, werden diese Liganden häufig als Hilfsliganden (d.h., sie sind nicht an dem für die Emission verantwortlichen **T₁-S₀** Übergang beteiligt) in lumineszierenden Übergangsmetallkomplexen verwendet. In den Patenten WO 2005118606 (H. Konno), CN 1624070 A (Z. H. Lin) und US 20020182441 A1 (M. E. Thompson et al.) werden umfassend Ir(III), Pt(II), Os(II)-Komplexe als Emitter beschrieben, die cyclometallierenden Liganden vom Typ 2-Phenylpyridin als Chromophore sowie Pyrazolyl-borate als Hilfsliganden enthalten.

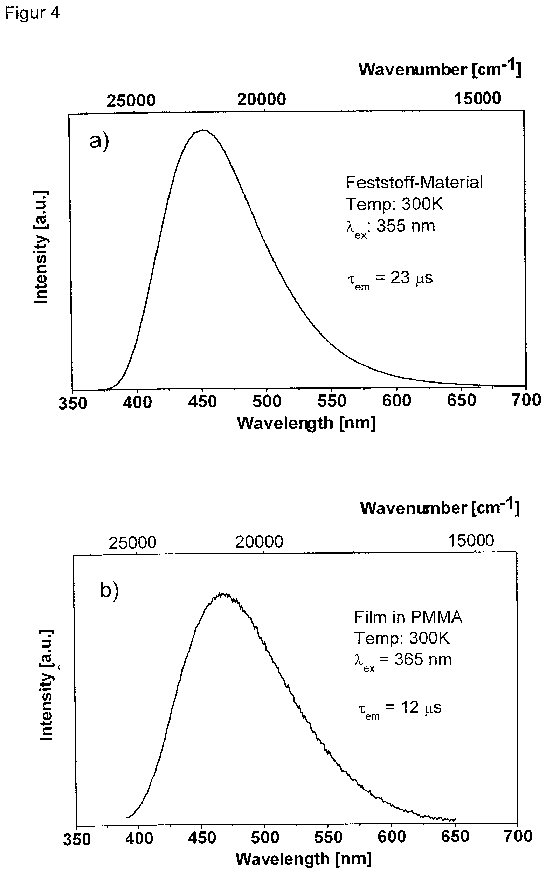

Die dargestellte Kombination von A) einfach negativ geladenen Stickstoffliganden N-B-N (bzw. N-B"-N und N∩N) und neutralen Liganden L oder L-B'-L sowie von B) neutralen Liganden N-B"-N (bzw. N'∩N') und einfach negativ geladenen Liganden L-B"'-L in einem Metall-Komplex mit einem vierfach-koordinierten Cu(I)-Zentralion führt überraschenderweise zu stark photolumineszierenden Materialien. An dem der Emission zugrunde liegenden elektronischen Übergang, der mit dem HOMO-LUMO-Übergang verbunden ist, sind sowohl das Metallatom als auch die (hetero)-aromatischen Teile beider Liganden N-B-N (bzw. N-B"-N, N∩N) und L-B'-L bzw. N-B"-N (bzw. N'∩N') und L-B"'-L beteiligt. Dies ist in Fig. 4 veranschaulicht, die beispielhaft die Grenzorbitale für einen Komplex zeigt.

Wie oben aufgeführt, werden die erfindungsgemäßen Verbindungen in einer elektronischen Vorrichtung verwendet. Dabei wird unter einer elektronischen Vorrichtung eine Vorrichtung verstanden, welche mindestens eine Schicht enthält, die mindestens eine organische Verbindung enthält. Das Bauteil kann dabei aber auch anorganische Materialien enthalten oder auch Schichten, welche vollständig aus anorganischen Materialien aufgebaut sind.

Die elektronische Vorrichtung ist bevorzugt ausgewählt aus der Gruppe bestehend aus organischen Elektrolumineszenzvorrichtungen (OLEDs), organischen integrierten Schaltungen (O-ICs), organischen Feld-Effekt-Transistoren (O-FETs), organischen Dünnfilmtransistoren (O-TFTs),

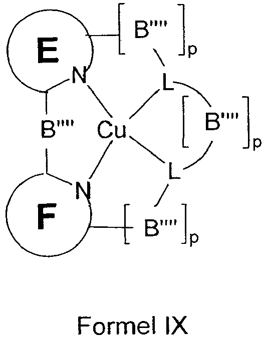

Dabei haben die N-Heterocyclen, die mit **E** und **F** bezeichnet sind, unabhängig voneinander dieselbe Bedeutung wie die Heterocyclen, die oben mit **A, B, C** oder **D** bezeichnet sind. B"" hat unabhängig voneinander dieselbe Bedeutung wie die oben genannten Brücken B, B', B" oder B"' oder kann auch für eine Einfachbindung stehen. Der Index p steht unabhängig voneinander für 0, 1, 2 oder 3, bevorzugt für 0, 1 oder 2, besonders bevorzugt für 0 oder 1, wobei mindestens ein Index p, weicher eine Brücke zwischen einem N-Heterocyclus und L beschreibt, ungleich 0 ist. Dabei bedeutet p = 0, dass keine Brücke B"" vorhanden ist. Um neutrale Komplexe zu erhalten, müssen dabei die Ladungen der N-Heterocyclen, die mit **E** und **F** bezeichnet sind, und der Brücken B"" entsprechend gewählt werden, dass sich die Ladungen mit der Ladung des Cu(I)-Ions kompensieren.

Wie oben aufgeführt, werden die erfindungsgemäßen Verbindungen in einer elektronischen Vorrichtung verwendet. Dabei wird unter einer elektronischen Vorrichtung eine Vorrichtung verstanden, welche mindestens eine Schicht enthält, die mindestens eine organische Verbindung enthält. Das Bauteil kann dabei aber auch anorganische Materialien enthalten oder auch Schichten, welche vollständig aus anorganischen Materialien aufgebaut sind.

Die elektronische Vorrichtung ist bevorzugt ausgewählt aus der Gruppe bestehend aus organischen Elektrolumineszenzvorrichtungen (OLEDs), organischen integrierten Schaltungen (O-ICs), organischen Feld-Effekt-Transistoren (O-FETs), organischen Dünnfilmtransistoren (O-TFTs), organischen lichtemittierenden Transistoren (O-LETs), organischen Solarzellen (O-SCs), organischen optischen Detektoren, organischen Photorezeptoren, organischen Feld-Quench-Devices (O-FQDs), lichtemittierenden elektrochemischen Zellen (LECs), organischen Laserdioden (O-Laser), OLED-Sensoren, insbesondere nicht hermetisch nach außen abgeschirmte Gas- und Dampf-Sensoren, und "organic plasmon emitting devices" (D. M. Koller et al., Nature Photonics 2008, 1-4), bevorzugt aber organischen Elektrolumineszenzvorrichtungen (OLEDs).

Die organische Elektrolumineszenzvorrichtung enthält Kathode, Anode und mindestens eine emittierende Schicht. Außer diesen Schichten kann sie noch weitere Schichten enthalten, beispielsweise jeweils eine oder mehrere Lochinjektionsschichten, Lochtransportschichten, Lochblockierschichten, Elektronentransportschichten, Elektroneninjektionsschichten, Exzitonenblockierschichten und/oder Ladungserzeugungsschichten (Charge-Generation Layers). Ebenso können zwischen zwei emittierende Schichten Interlayer eingebracht sein, welche beispielsweise eine exzitonenblockierende Funktion aufweisen. Es sei aber darauf hingewiesen, dass nicht notwendigerweise jede dieser Schichten vorhanden sein muss. Dabei kann die organische Elektrolumineszenzvorrichtung eine emittierende Schicht enthalten, oder sie kann mehrere emittierende Schichten enthalten. Wenn mehrere Emissionsschichten vorhanden sind, weisen diese bevorzugt insgesamt mehrere Emissionsmaxima zwischen 380 nm und 750 nm auf, so dass insgesamt weiße Emission resultiert, d. h. in den emittierenden Schichten werden verschiedene emittierende Verbindungen verwendet, die fluoreszieren oder phosphoreszieren können. Insbesondere bevorzugt sind Dreischichtsysteme, wobei die drei Schichten blaue, grüne und orange oder rote Emission zeigen (für den prinzipiellen Aufbau siehe z. B. WO 05/011013).

In einer bevorzugten Ausführungsform der Erfindung werden die erfindungsgemäßen Komplexe der Formel A und I bis IX als Triplettemitter in einer Emitterschicht eines lichtemittierenden optoelektronischen Bauelements eingesetzt werden. Insbesondere durch eine geeignete Kombination der Liganden N-B-N (bzw. N-B"-N und N∩N) und L bzw. L-B'-L können Emittersubstanzen auch für blaue Emissionsfarben erhalten werden (siehe unten, Beispiele 1-3), wobei bei der Verwendung anderer Liganden mit niedriger liegenden Triplettzuständen auch lichtemittierende Cu(I)-Komplexe mit anderen Emissionsfarben (grün, rot) synthetisiert werden können (siehe auch Beispiel 4).

Die Komplexe der Formel A und I bis IX können erfindungsgemäß auch als Absorbermaterialien in einer Absorberschicht eines optoelektronischen Bauelements eingesetzt werden, beispielsweise in organischen Solarzellen.

Der Anteil des Kupfer(I)-Komplexes an der Emitter- oder Absorberschicht in einem derartigen optoelektronischen Bauelement beträgt in einer Ausführungsform der Erfindung 100 %. In einer alternativen Ausführungsform beträgt der Anteil des Kupfer(I)-Komplexes an der Emitter- oder Absorberschicht 1 % bis 99 %.

Vorteilhafterweise beträgt die Konzentration des Kupfer(I)-Komplexes als Emitter in optischen Licht emittierenden Bauelementen, insbesondere in OLEDs, zwischen 1 % und 10 %.

Geeignete Matrixmaterialien, die in Kombination mit dem Kupfer(I)-Komplex verwendet werden können, sind bevorzugt ausgewählt aus aromatischen Ketonen, aromatischen Phosphinoxiden oder aromatischen Sulfoxiden oder Sulfonen, z. B. gemäß WO 04/013080, WO 04/093207, WO 06/005627 oder der nicht offen gelegten Anmeldung DE 102008033943.1, Triarylaminen, Carbazolderivaten, z. B. CBP (N,N-Bis-carbazolylbiphenyl) oder die in WO 05/039246, US 2005/0069729, JP 2004/288381, EP 1205527 oder WO 08/086851 offenbarten Carbazolderivate, Indolocarbazolderivaten, z. B. gemäß WO 07/063754 oder WO 08/056746, Azacarbazolderivaten, z. B. gemäß EP 1617710, EP 1617711, EP 1731584, JP 2005/347160, bipolaren Matrixmaterialien, z. B. gemäß WO 07/137725, Silanen, z. B. gemäß WO 05/111172, Azaborolen oder Boronestern, z. B. gemäß WO 06/117052, Triazinderivaten, z. B. gemäß der nicht offen gelegten Anmeldung DE 102008036982.9, WO 07/063754 oder WO 08/056746, Zinkkomplexen, z. B. gemäß EP 652273 oder WO 09/062578 oder Diazasilol- bzw. Tetraazasilol-Derivaten, z. B. gemäß der nicht offen gelegten Anmeldung DE 102008056688.8. Es kann auch bevorzugt sein, eine Mischung aus zwei oder mehr dieser Matrixmaterialien zu verwenden, insbesondere aus mindestens einem lochtransportierendem und mindestens einem elektronentransportierenden Matrixmaterial.

Es ist auch möglich, die erfindungsgemäßen Verbindungen in einer anderen Schicht der organischen Elektrolumineszenzvorrichtung zu verwenden, beispielsweise in einer Lochinjektions- oder -transportschicht oder in einer Elektronentransportschicht. Durch die vergleichsweise leichte Oxidierbarkeit des Kupfer(I)-lons eignen sich die Materialien insbesondere auch als Lochinjektions- bzw. Lochtransportmaterial.

Generell können erfindungsgemäß für die weiteren Schichten alle üblicherweise auf dem Gebiet der organischen Halbleiter, insbesondere auf dem Gebiet der organischen Elektrolumineszenzvorrichtungen verwendeten weiteren Materialien, beispielsweise Lochinjektions- und -transportmaterialien, Elektroneninjektions- und -transportmaterialien, Lochblockiermaterialien, Exzitonenblockiermaterialien, etc. eingesetzt werden. Der Fachmann kann daher ohne erfinderisches Zutun alle für organische Elektrolumineszenzvorrichtungen bekannten Materialien in Kombination mit den erfindungsgemäßen Verbindungen einsetzen.

Gegenstand der vorliegenden Erfindung sind auch elektronische Vorrichtungen, insbesondere die oben aufgeführten elektronischen Vorrichtungen, die einen hier beschriebenen Kupfer(I)-Komplex aufweisen. Dabei kann das elektronische Bauelement bevorzugt ausgeformt sein als ein organisches lichtemittierendes Bauelement, eine organische Diode, eine organische Solarzelle, ein organischer Transistor, eine organische lichtemittierende Diode, eine Licht-emittierende elektrochemische Zelle, ein organischer Feldeffekttransistor und als ein organischer Laser.

Weiterhin bevorzugt ist eine elektronische Vorrichtung, insbesondere eine organische Elektrolumineszenzvorrichtung, dadurch gekennzeichnet, dass eine oder mehrere Schichten mit einem Sublimationsverfahren beschichtet werden. Dabei werden die Materialien in Vakuum-Sublimationsanlagen bei einem Anfangsdruck kleiner 10⁻⁵ mbar, bevorzugt kleiner 10⁻⁶ mbar aufgedampft. Es ist aber auch möglich, dass der Anfangsdruck noch geringer ist, beispielsweise kleiner 10⁻⁷ mbar.

Bevorzugt ist ebenfalls eine elektronische Vorrichtung, insbesondere eine organische Elektrolumineszenzvorrichtung, dadurch gekennzeichnet, dass eine oder mehrere Schichten mit dem OVPD (Organic Vapour Phase Deposition) Verfahren oder mit Hilfe einer Trägergassublimation beschichtet werden. Dabei werden die Materialien bei einem Druck zwischen 10⁻⁵ mbar und 1 bar aufgebracht. Ein Spezialfall dieses Verfahrens ist das OVJP (Organic Vapour Jet Printing) Verfahren, bei dem die Materialien direkt durch eine Düse aufgebracht und so strukturiert werden (z. B. M. S. Arnold et al., Appl. Phys. Lett. 2008, 92, 053301).

Weiterhin bevorzugt ist eine elektronische Vorrichtung, insbesondere eine organische Elektrolumineszenzvorrichtung, dadurch gekennzeichnet, dass eine oder mehrere Schichten aus Lösung, wie z. B. durch Spincoating, oder mit einem beliebigen Druckverfahren, wie z. B. Siebdruck, Flexodruck oder Offsetdruck, besonders bevorzugt aber LITI (Light Induced Thermal Imaging, Thermotransferdruck) oder Ink-Jet Druck (Tintenstrahldruck), hergestellt werden. Hierfür sind lösliche Verbindungen nötig, welche beispielsweise durch geeignete Substitution erhalten werden. Das Aufbringen kann auch nass-chemisch mittels kolloidaler Suspension erfolgen. Wenn das Aufbringen nass-chemisch mittels kolloidaler Suspension erfolgt, ist die Partikelgröße bevorzugt < 10 nm, besonders bevorzugt < 1 nm.

Diese Verfahren sind dem Fachmann generell bekannt und können von ihm ohne erfinderisches Zutun auf organische Elektrolumineszenzvorrichtungen enthaltend die erfindungsgemäßen Verbindungen angewandt werden. Ebenso sind Hybridverfahren möglich, bei denen mehrere der oben genannten Verfahren für unterschiedliche Schichten kombiniert werden. Diese Verfahren sind ebenfalls ein Gegenstand der vorliegenden Erfindung.

Die erfindungsgemäßen Verbindungen eignen sich sehr gut für die Verwendung in elektronischen Vorrichtungen und führen insbesondere bei Verwendung in einer organischen Elektrolumineszenzvorrichtung zu hohen Effizienzen, langen Lebensdauern und guten Farbkoordinaten.

### Figuren

Vorteilhafte Ausgestaltungen ergeben sich insbesondere aus den in den Figuren gezeigten erfindungsgemäßen Kupfer(I)-Komplexen und den mit ihnen gewonnenen experimentellen Daten. Es zeigt:
- Figur 1: eine schematische und vereinfachte Darstellung zur Funktionsweise eines OLEDs (die aufgebrachten Schichten sind z. B. nur ca. 300 nm dick);
- Figur 2: Grenzorbital-Konturen: HOMO (links) und LUMO (rechts) von [Cu(pz₂BH₂)(pop)] (siehe Beispiel 1) (Die DFT Rechnungen wurden auf dem B3LYP/LANL2DZ Theorie-Niveau durchgeführt. Als Startgeometrie diente die Kristallstruktur von [Cu(pz₂BH₂)(pop)]);
- Figur 3: ein ORTEP-Bild eines [Cu(H₂Bpz₂)(pop)] Moleküls;
- Figur 4: Photolumineszenzspektren von [Cu(H₂Bpz₂)(pop)] untersucht als reines polykristallines Material (a) und als Dopant in einem PMMA-Film (b);
- Figur 5: ein ORTEP-Bild eines [Cu(H₂B(5-Me-pz)₂)(pop)] Moleküls;
- Figur 6: ein Photolumineszenzspektrum von [Cu(H₂B(5-Me-pz)₂)(pop)] als reines polykristallines Material;
- Figur 7: eine ORTEP-Bild eines [Cu(Bpz₄)(pop)] Moleküls;
- Figur 8: ein Photolumineszenzspektrum von [Cu(Bpz₄)(pop)] als reines polykristallines Material;
- Figur 9: ein ORTEP-Bild eines [Cu(H₂Bpz₂)(dppb)] Moleküls;
- Figur 10: ein Photolumineszenzspektrum von [Cu(Bpz₄)(pop)] als reines polykristallines Material;
- Figur 11: ein Beispiel für ein OLED-Device mit einer einen erfindungsgemäßen Kupferkomplex aufweisenden Emitterschicht, die nasschemisch aufgetragen werden kann (die Angaben der Schichtdicken sind Beispielwerte);
- Figur 12: ein Beispiel eines mittels Vakuum-Sublimationstechnik herstellbaren OLED-Devices mit erfindungsgemäßen Komplexen in der Emitterschicht; und
- Figur 13: ein Beispiel für ein differenziertes, hocheffizientes OLED-Device aufweisend einen sublimierbaren erfindungsgemäßen Kupferkomplex als Emittermaterial.

### Referenzen

[i] C. Adachi, M. A. Baldo, S. R. Forrest, S. Lamansky, M. E. Thompson, R. C. Kwong, Appl. Phys. Lett. 2001, 78, 1622.
[ii] X. H. Yang, D. C. Müller, D. Neher, K. Meerholz, Adv. Mater. 2006, 18, 948; X. H. Yang, D. Neher, Appl. Phys. Lett. 2004, 84, 2476.
[iii] J. Shinar (Hrsg.), Organic light-emitting devices - A survey, AIP-Press, Springer, New York, 2004**.**
[iv] H. Yersin, Top. Curr. Chem. 2004, 241, 1.
[v] H. Yersin (Hrsg.), Highly Efficient OLEDs with Phosphorescent Materials, Wiley-VCH, Weinheim 2008**.**
[vi] Z. H. Kafafi, Organic Electroluminescence, Taylor & Francis, Boca Raton, 2005**.**
[vii] M. E. Thompson, P. I. Djurovich, J. Li (University of Southern California, Los Angeles, CA), WO 2004/017043 A2, 2004**.**
[viii] M. E. Thompson, P. I. Djurovich, R. Kwong (University of Southern California, Los Angeles, CA, Universal Display Corp, Ewing, NY), WO 2004/016711 A1, 2004**.**
[ix] A. Tsuboyama, S. Okada, T. Takiguchi, K. Ueno, S. Igawa, J. Kamatani, M. Furugori, H. Iwawaki (Canon KK, Tokyo), WO 03/095587 A1, 2003**.**
[x] C.-M. Che, US 2003/0205707 A1, 2003**.**
[xi] C.-M. Che, W. Lu, M. C.-W. Chan, US 2002/0179885 A1, 2002**.**
[xii] J. Kamatani, S. Okada, A. Tsuboyama, T. Takiguchi, S. Igawa, US 2003/186080 A1, 2003**.**
[xiii] P. Stößel, I. Bach, A. Büsing (Covion Organic Semiconductors GmbH), DE 10350606 A1, 2005**.**
[xiv] M. Bold, C. Lennartz, M. Egen, H.-W. Schmidt, M. Thelakkat, M. Bäte, C. Neuber, W. Kowalsky, C. Schildknecht (BASF AG), DE 10338550 A1, 2005**.**
[xv] C. Lennartz, A. Vogler, V. Pawlowski (BASF AG), DE 10358665 A1, 2005**.**
[xvi] B. Hsieh, T. P. S. Thoms, J. P. Chen (Canon KK, Tokyo), US 2006/989273 B2, 2006**.**
[xvii]N. Schulte, S. Heun, I. Bach, P. Stoessel, K. Treacher (Covion Organic Semiconductors), WO 2006/003000 A1, 2006**.**
[xviii]A. Vogler, V. Pawlowski, H.-W. Schmidt, M. Thelakkat (BASF AG), WO 2006/032449 A1, 2006**.**
[xix] T. K. Hatwar, J. P. Spindler, R. H. Young (Eastman Kodak Co), WO 2006/028546 A1, 2006**.**
[xx] P. A. Breddels, P. A. M. Berdowski, G. Blasse, D. R. McMillin, J. Chem. Soc., Faraday Trans. 1982, 78, 595; S.-M. Kuang, D. G. Cuttell, D. R. McMillin, P. E. Fanwick, R. A. Walton, Inorg. Chem. 2002, 41, 3313; D. G. Cuttel, S.-M. Kuang, P. E. Fanwick, D. R. McMillin, R. A. Walton, J Am. Chem. Soc. 2002, 124, 6.
[xxi] K. R. Kyle, C. K. Ryu, J. A. DiBenedetto, P. C. Ford, J. Am. Chem. Soc. 1991, 113, 2954;H. Araki, K. Tsuge, Y. Sasaki, S. Ishizaka, N. Kitamura, Inorg. Chem. 2005, 44, 9667.
[xxii] A. Tsuboyama, K. Kuge, M. Furugori, S. Okada, M. Hoshino, K. Ueno, Inorg. Chem. 2007, 46, 1992*.*
[xxiii]M. T. Buckner, D. R. McMillin, J. C. S. Chem. Comm., 1978, 759;R. A. Rader, D. R. McMillin, M. T. Buckner, T. G. Matthews, D. J. Casadonte, R. K. Lengel, S. B. Whittaker, L. M. Darmon, F. E. Lytle, J. Am. Chem. Soc. 1981, 103, 5906; C. E. A. Palmer, D. R. McMillin, Inorg. Chem. 1987, 26, 3837.
[xxiv]C.-L. Chan, K.-L. Cheung, W. H. Lam, E. C.-C. Cheng, N. Zhu, S. W.-K. Choi, V. W.-W. Yam, Chem. Asian J. 2006, 1-2, 273*.*
[xxv]V. Palowski, G. Knör, C. Lennartz, A. Vogler, Eur. J. Inorg. Chem. 2005, 3167.
[xxvi]M. I. Bruce, N. N. Zaitseva, B. W. Skelton, N. Somers, A. H. White, Inorg. Chim. Acta 2007, 360, 681.
[xxvii]Y. Ma, C.-M. Che, H.-Y. Chao, X. Zhou, W.-H. Chan, J. Shen, Adv. Mater. 1999, 11, 852.
[xxviii]Q. Zhang, Q. Zhou, Y. Cheng, L. Wang, D. Ma, X. Jing, F. Wang, Adv. Mater. 2004, 16, 432; N. Armaroli, G. Accorsi, M. Holler, O. Moudam, J.-F. Nierengarten, Z. Zhou, R. T. Wegh, R. Welter, Adv. Mater. 2006, 18, 1313.
[xxix]Q. Zhang, Q. Zhou, Y. Cheng, L. Wang, D. Ma, X. Jing, F. Wang, Adv. Funct. Mater. 2006, 16, 1203; Q. Zhang, J. Ding, Y. Cheng, L. Wang, Z. Xie, X. Jing, F. Wang, Adv. Funct. Mater. 2007, 17, 2983.

### Beispiele

Die Erfindung wird nun anhand von Beispielen unter Bezugnahme auf Figuren erläutert, ohne sie dadurch einschränken zu wollen. Der Fachmann kann aus den Schilderungen die Erfindung im gesamten offenbarten Bereich ausführen und ohne erfinderisches Zutun weitere erfindungsgemäße Komplexe herstellen und diese in elektronischen Vorrichtungen verwenden bzw. das erfindungsgemäße Verfahren anwenden.

### Beispiel 1

### [Cu(H₂Bpz₂)(pop)]

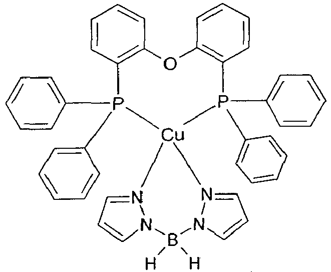

### Darstellung

Eine Lösung von [Cu(CH₃CN)₄](PF₆) (0.186 g, 0.500 mmol) und Bis(2-diphenylphosphinophenyl)ether (pop, 0.269 g, 0.500 mmol) in Acetonitril (15 ml) wird 30 min. unter Argonatmosphäre gerührt. Danach wird K[H₂Bpz₂] (0.093 g, 0.500 mmol) zu der Lösung hinzugegeben und die daraus resultierende Mischung wird weitere 2 Stunden unter Argonatmosphäre gerührt. Der entstehende, weiße Niederschlag wird abgefiltert und dreimal mit 5 ml Acetonitril gewaschen. Ausbeute 0.313 g, 84 %.

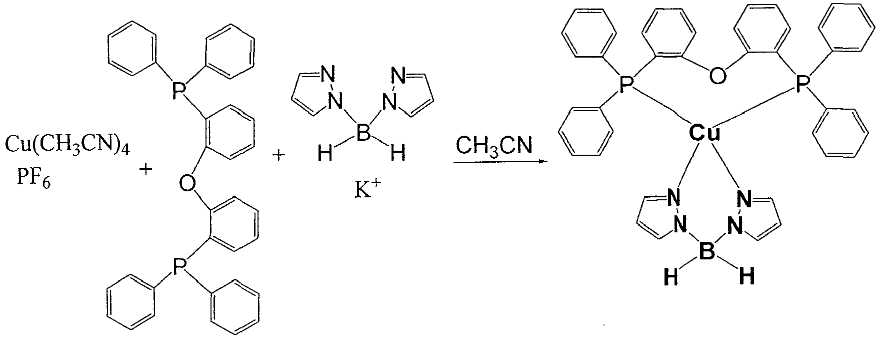

¹H-NMR (CDCl₃, 298 K): *δ* 7.59 (d, 2H), 7.05-7.22 (m, br, 20H), 6.78-6.87 (m, br, 6H), 6.68-6.71 (m, br, 2H), 5.84 (t, 2H), 5.30(s, 2H). ¹³C{¹H}-NMR: *δ* 128.2, 129.2, 130.6, 132.8, 134.0, 134.3, 140.1. ³¹P{¹H}-NMR: *δ* -17.23 (s), -18.75 (s). ES-MS: *m*/*z* = 749.3 (MH⁺, 100.0 %), 750.3 (58.0 %), 748.2 (24.0 %), 752.3 (21.5 %), 753.3 (4.8 %). EA: gef. C, 61.72; H, 4.52; N, 6.72%; ber. C, 61.93; H, 4.59; N, 6.72 (für C₄₃H₃₈BCuN₄OP₂Cl₂).

### Kristallstruktur

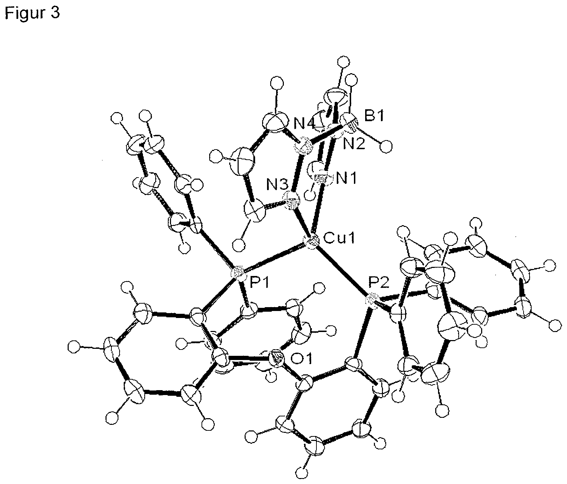

Ein ORTEP-Bild dieses Komplexes ist in Figur 3 dargestellt.

### Photolumineszenz-Eigenschaften

Die Photolumineszenz-Eigenschaften dieses Komplexes sind in Figur 4 dargestellt.

### Beispiel 2

### [Cu(H₂B(5-Me-pz)₂)(pop)]

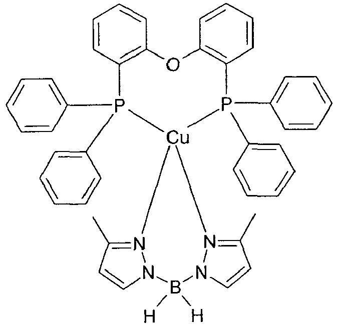

### Darstellung

Der Syntheseweg ist analog zu [Cu(H₂Bpz₂)(pop)] (Beispiel 1). Ausbeute 81%. ¹H-NMR (CDCl₃, 298 K): *δ* 7.52 (d, 2H), 7.35-7.29 (m, br, 10H), 7.22 (d, 4H), 7.12 (t, 8H), 6.99 (td, 2H), 6.86 (td, 2H), 6.72-6.67 (m, br, 2H). 6.61-6.58 (m, 2H), 5.76 (d, 2H), 1.46 (s, 6H). ¹³C{¹H}-NMR: *δ* 14.07, 103.1, 119.6, 124.1, 128.1, 128.2, 129.2, 130.4, 132.5, 132.6, 133.8, 133.4, 134.5, 134.7, 135.4, 148.9, 157.0. ³¹P{¹H}-NMR: *δ* -14.89 (s), -16.18 (s),-17.14 (s). ES-MS: *m*/*z* = MH⁺, 772.2 (100.0 %), 778.2 (57.0 %), 780.2 (22.2 %), 781.2 (6.8 %). EA: gef. C, 68.45; H, 5.10; N, 7.33%; ber. C, 68.00; H, 5.19; N, 7.21 (für C₄₉H₄₃BCuN₈OP₂Cl₂).

### Kristallstruktur

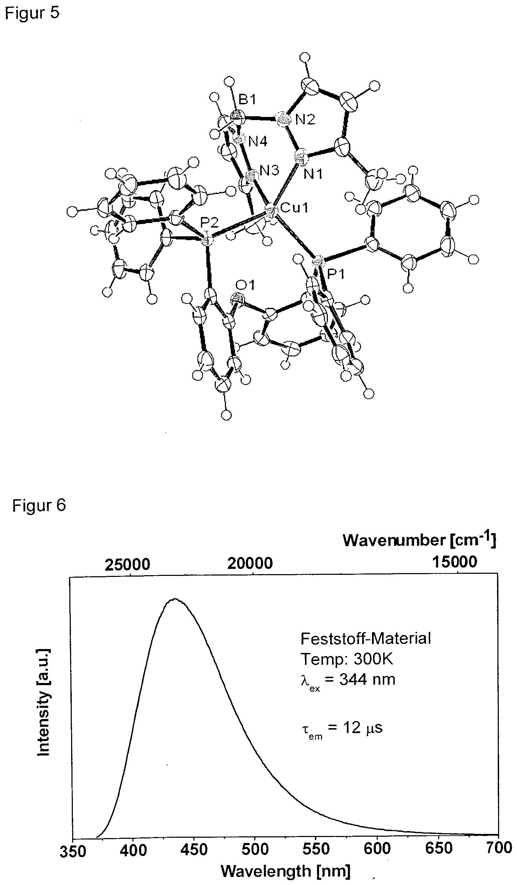

Ein ORTEP-Bild dieses Komplexes ist in Figur 5 dargestellt.

### Photolumineszenz-Eigenschaften

Die Photolumineszenz-Eigenschaften dieses Komplexes sind in Figur 6 dargestellt.

### Beispiel 3

### [Cu(Bpz₄)(pop)]

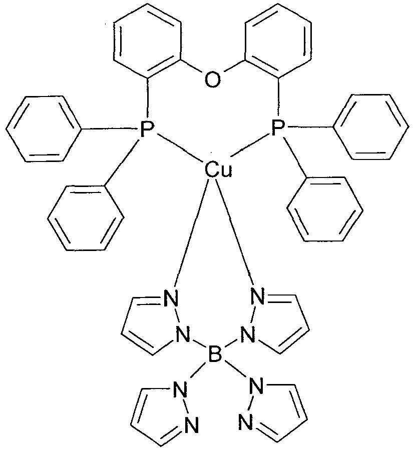

### Darstellung

Der Syntheseweg ist analog zu [Cu(H₂Bpz₂)(pop)] (Beispiel 1). Ausbeute 79 %. ¹H-NMR (CDCl₃, 298 K): *δ* 7.38 (br, 4H), 7.05-7.24 (m, br, 20H), 6.76-6.98 (m, br, 6H), 6.68-6.71 (m, br, 2H), 5.85 (t, 4H), 5.30 (s, 4H). ¹³C{¹H}-NMR: *δ* 104.4, 106.3, 120.3 124.4, 124.8, 126.4, 128.2, 128.3, 128.5, 128.6, 129.3, 129.7, 130.8, 131.5, 131.6, 131.8, 132.0, 133.2, 133.3, 133.4, 133.8, 134.0, 134.1, 135.3, 135.9, 141.7, 157.8, 157.9, 158.1. ³¹P{¹H}-NMR: *δ* -14.37 (s). ES-MS: *mlz* = 881.4 (MH⁺,100.0 %), 882.4 (63.0 %), 883.4 (59.0 %), 884.3 (26,1 %), 880.4 (23,2 %), 885.4 (6,3 %), 886.3 (1,4 %). EA: gef. C, 61.55; H, 4.48; N, 11,63 %; ber. C, 60.85; H, 4.48; N, 11.59 (für C₄₉H₄₃BCuN₈OP₂Cl₂)

### Kristallstruktur

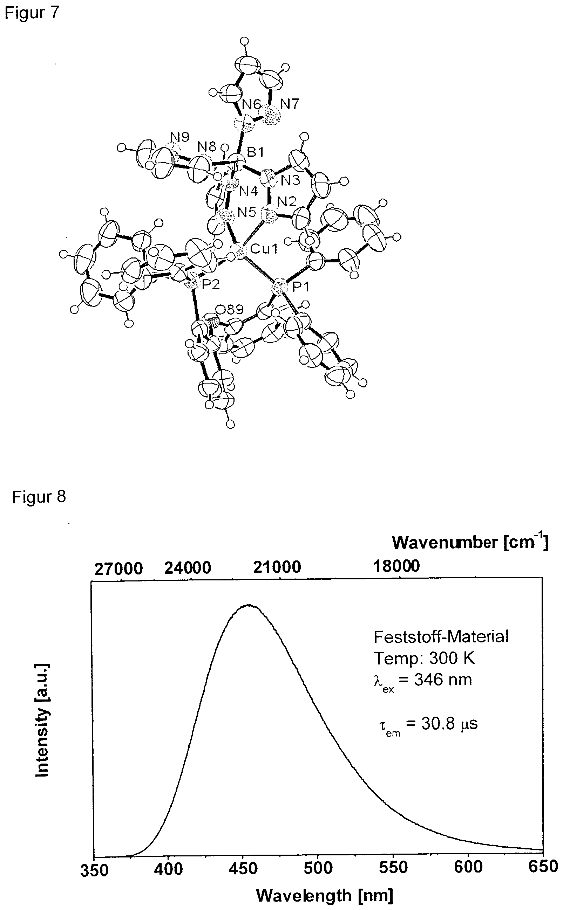

Ein ORTEP-Bild dieses Komplexes ist in Figur 7 dargestellt.

### Photolumineszenz-Eigenschaften

Das Photolumineszenzspektrum dieses Komplexes ist in Figur 5 dargestellt.

### Beispiel 4

### [Cu(H₂Bpz₂)(dppb)]

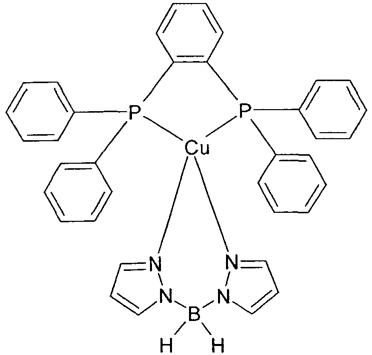

### Syntheseweg

Der Syntheseweg ist analog zu [Cu(H₂Bpz₂)(pop)] (Beispiel 1). Ausbeute 80 %. ¹H-NMR (CDCl₃, 298 K): *δ* 7.38 (br, 4H), 7.05-7.24 (m, br, 20H), 6.76-6.98 (m, br, 6H), 6.68-6.71 (m, br, 2H), 5.85 (t, 4H), 5.30 (s, 4H). ¹³C{¹H}-NMR: *δ* 103.0, 128.4, 128.5, 128.6, 128.9, 129.0, 129.2, 130.3, 132.5, 132.9, 133.0, 133.1, 133.8, 134.1, 134.3, 134.5, 134.6, 134.7, 139.9, 142.7, 143.2, 143.6. ³¹P{¹H}-NMR: *δ* -1.96 (s), -7.37 (s). ES-MS: *m*/*z* = 657.1 (MH⁺, 100.0 %), 658.1 (52.4 %), 656.1 (34.6 %), 660.1 (14.1 %), 661.1 (4.2 %). EA: gef.: C, 65.42; H, 4.86; N, 8.42 %; ber.: C, 65.81; H, 4.91; N, 8.53 (für C₄₉H₄₃BCuN₈OP₂).

### Kristallstruktur

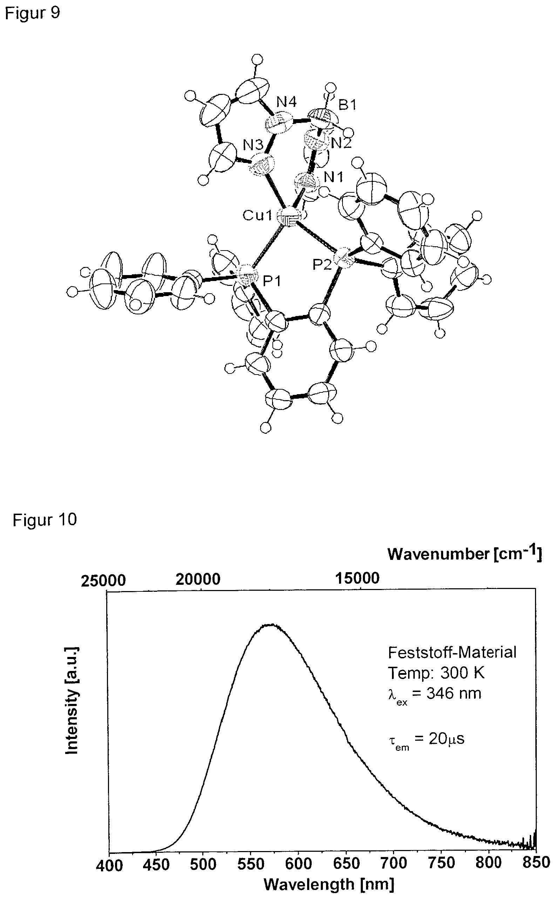

Ein ORTEP-Bild dieses Komplexes ist in Figur 9 dargestellt.

### Photolumineszenz-Eigenschaften

Das Photolumineszenzspektrum von [Cu(Bpz₄)(pop)] als reines polykristallines Material ist in Figur 10 dargestellt.

### Beispiel 5: OLED-Devices

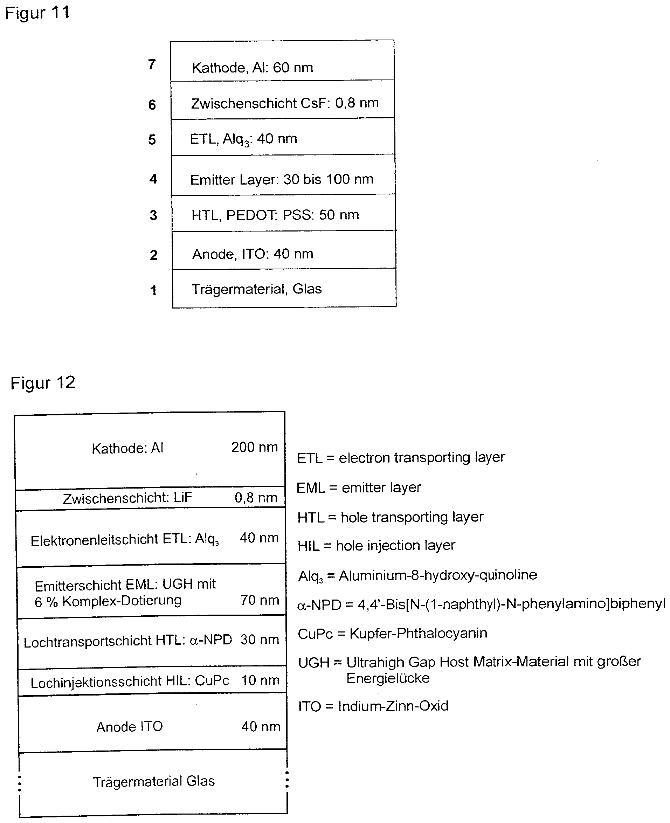

Die erfindungsgemäßen Kupferkomplexe können in einem OLED-Device als Emittersubstanzen verwendet werden. Zum Beispiel lassen sich in einem typischen OLED-Schichtaufbau, bestehend aus einer ITO-Anode, einem Lochleiter aus PEDOT/PSS, der erfindungsgemäßen Emitterschicht, gegebenenfalls einer Lochblockierschicht, einer Elektronenleiterschicht, einer dünnen LiF- oder CsF-Zwischenschicht zur Verbesserung der Elektroneninjektion sowie einer Metall-Elektrode (Kathode) gute Leistungseffizienzen erzielen. Diese verschiedenen Schichten mit einer Gesamtdicke von einigen 100 nm lassen sich z. B. auf einem Glassubstrat oder einem sonstigen Trägermaterial aufbringen. Ein entsprechendes Muster-Device ist in Figur 11 dargestellt.

Die Bedeutung der in Figur 11 gezeigten Schichten ist wie folgt:
**1.** Als Trägermaterial kann Glas oder jedes andere geeignete feste oder flexible durchsichtige Material verwendet werden.
**2.** ITO = Indium-Zinn-Oxid
**3.** PEDOT/PSS = Poly-ethylendioxythiophen/Polystyrolsulfonsäure. Hierbei handelt es sich um ein Lochleitermaterial (HTL = *hole transport layer*), das wasserlöslich ist.
**4.** Emitter-Layer, häufig mit EML abgekürzt, mit erfindungsgemäßer Emittersubstanz. Dieses Material kann z. B. in organischen Lösungsmitteln gelöst werden, womit ein Auflösen der darunter liegenden PEDOT/PSS-Schicht vermieden werden kann. Die erfindungsgemäße Emittersubstanz wird in einer Konzentration verwendet, die Selfquench-Prozesse oder Triplett-Triplett-Annihilationen verhindert oder stark einschränkt. Es erweisen sich Konzentrationen größer 2 % und kleiner 12 % als gut geeignet.
**5**. ETL = Elektronentransportmaterial (ETL = *electron transport layer*)*.* Zum Beispiel kann das aufdampfbare Alq₃ verwendet werden. Dicke ist z. B. 40 nm.
**6.** Die sehr dünne Zwischenschicht aus z. B. CsF oder LiF verringert die Elektroneninjektionsbarriere und schützt die ETL-Schicht. Diese Schicht wird in der Regel aufgedampft. Für einen weiter vereinfachten OLED-Aufbau können gegebenenfalls die ETL- und die CsF-Schicht entfallen.
**7.** Die leitende Kathodenschicht wird aufgedampft. Al repräsentiert ein Beispiel. Es können auch Mg:Ag (10:1) oder andere Metalle verwendet werden.

Die am Device anliegende Spannung beträgt z. B. 3 bis 15 V.

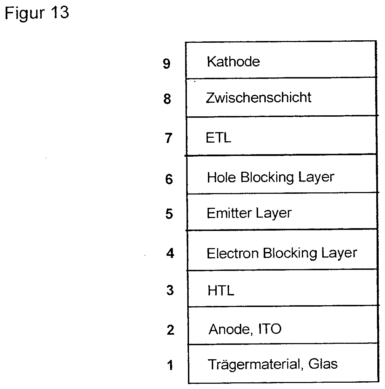

Weitere Ausführungsformen zeigen die Figuren 12 und 13, in denen OLED-Devices mit den erfindungsgemäßen Emittersubstanzen mittels Vakuum-Sublimationstechnik erstellt werden.

Die Bedeutung der in Figur 13 gezeigten Schichten ist wie folgt:
**1.** Als Trägermaterial kann Glas oder jedes andere geeignete feste oder flexible durchsichtige Material verwendet werden.
**2.** ITO = Indium-Zinn-Oxid
**3.** HTL = *hole transport layer.* Hierfür kann z. B. α-NPD in einer Dicke von z. B. 40 nm eingesetzt werden. Der in Fig. 13 gezeigte Aufbau kann ergänzt werden durch eine geeignete weitere Schicht zwischen der Schicht **2** und **3,** die die Lochinjektion verbessert (z. B. Kupfer-Phthalocyanin (CuPc, z. B. 10 nm dick)).
**4.** Die Elektronen-Blockierschicht soll dafür sorgen, dass der Elektronentransport zur Anode unterbunden wird, da dieser Strom nur ohmsche Verluste verursachen würde (Dicke z. B. 30 nm). Auf diese Schicht kann verzichtet werden, wenn die HTL-Schicht bereits intrinsisch ein schlechter Elektronenleiter ist.
**5.** Die Emitter-Schicht enthält oder besteht aus dem erfindungsgemäßen Emittermaterial. Dieses kann für die sublimierbaren erfindungsgemäßen Materialien durch Sublimation aufgetragen werden. Die Schichtdicke kann z. B. zwischen 50 nm und 200 nm liegen. Für im Grünen oder im Roten emittierende erfindungsgemäße Emittermaterialien eignen sich die gängigen Matrixmaterialien wie CBP (4,4'-Bis-(N-carbazolyl)-biphenyl). Für im Blauen emittierende erfindungsgemäße Emittermaterialien können UHG-Matrixmaterialien (siehe z. B. M.E. Thompson et al., Chem. Mater. 2004, 16, 4743) oder andere sogenannten Wide-Gap-Matrixmaterialien eingesetzt werden.
**6.** Die *Hole-Blocking*-Schicht soll die ohmschen Verluste reduzieren, die durch Lochströme zur Kathode entstehen. Diese Schicht kann z. B. 20 nm dick sein. Als Material eignet sich z. B. BCP (4,7-Diphenyl-2,9-dimethyl-phenanthrolin = Bathocuproin).
**7.** ETL = Elektronentransportmaterial (ETL = *electron transport layer*)*.* Zum Beispiel kann das aufdampfbare Alq₃ verwendet werden. Dicke ist z. B. 40 nm.
**8.** Die sehr dünne Zwischenschicht aus z. B. CsF oder LiF verringert die Elektroneninjektionsbarriere und schützt die ETL-Schicht. Diese Schicht wird in der Regel aufgedampft.
**9.** Die leitende Kathodenschicht wird aufgedampft. Al repräsentiert ein Beispiel. Es können auch Mg:Ag (10:1) oder andere Metalle verwendet werden.

Die am Device anliegende Spannung beträgt z. B. 3 V bis 15 V.

### Beispiel 6: Herstellung und Charakterisierung von organischen Elektrolumineszenzvorrichtungen aus Lösung

Die Herstellung von LEDs erfolgt nach dem im Folgenden skizzierten allgemeinen Verfahren. Dieses wird im Einzelfall auf die jeweiligen Gegebenheiten (z. B. Schichtdickenvariation, um optimale Effizienz bzw. Farbe zu erreichen) angepasst.

### Allgemeines Verfahren zur Herstellung der OLEDs:

Die Herstellung solcher Bauteile lehnt sich an die Herstellung polymerer Leuchtdioden (PLEDs) an, die in der Literatur bereits vielfach beschrieben ist (z. B. in der WO 2004/037887 A2). Im vorliegenden Fall werden die erfindungsgemäßen Verbindungen zusammen mit den aufgeführten Matrixmaterialien oder Matrixmaterialkombinationen in Toluol, Chlorbenzol oder DMF gelöst. Der typische Feststoffgehalt solcher Lösungen liegt zwischen 10 und 25 g/L, wenn, wie hier, die für eine Device typische Schichtdicke von 80 nm mittels Spincoating erzielt werden soll.

Analog dem o. g. allgemeinen Verfahren werden OLEDs mit folgendem Aufbau erzeugt:

| | |
|---|---|
| PEDOT | 20 nm (aus Wasser aufgeschleudert; PEDOT bezogen von BAYER AG; Poly-[3,4-ethylendioxy-2,5-thiophen] |
| Matrix + Emitter | 80 nm, 10 Gew.-% Emitter (aus Toluol, Chlorbenzol oder DMF aufgeschleudert), |
| Ba / Ag | 10 nm Ba /150 nm Ag als Kathode. |

Strukturierte ITO-Substrate und das Material für die so genannte Pufferschicht (PEDOT, eigentlich PEDOT:PSS) sind käuflich erhältlich (ITO von Technoprint und anderen, PEDOT:PPS als wässrige Dispersion Clevios Baytron P von H.C. Starck).

Die Strukturen eines Emitters E1 nach Stand der Technik und der Matrices M und sind der Übersichtlichkeit halber im Folgenden abgebildet:

| | |
|---|---|
| 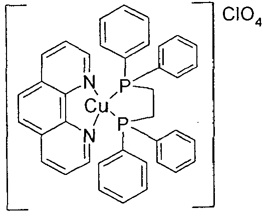 | 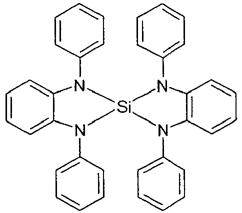 |
| Emitter E1 | M1 |
| (US 2005/0221115) | (DE10200856688.8) |
| 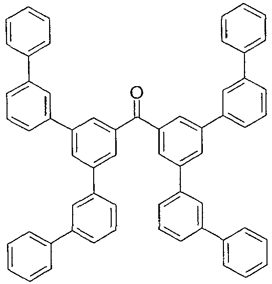 | 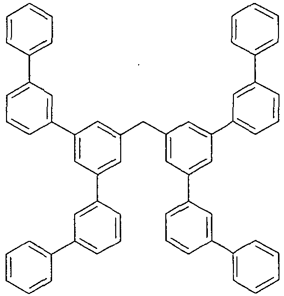 |
| M2 | M3 |
| (DE102008033943.1) | (DE102008033943.1) |

Die Emissionsschicht wird in einer Inertgasatmosphäre, im vorliegenden Fall Argon, aufgeschleudert und 10 min bei 120 °C ausgeheizt. Zuletzt wird eine Kathode aus Barium und Silber im Vakuum aufgedampft. Die lösungsprozessierten Devices werden standardmäßig charakterisiert, die genannten OLED-Beispiele sind noch nicht optimiert.

In Tabelle 1 sind die Effizienz und die Spannung bei 100 cd/m² sowie die Farbe aufgeführt.

**Tabelle 1: Device-Ergebnisse**

| **Bsp.** | **Matrix Emitter** | **EQE bei 100 cd/m² [%]** | **Spannung bei 100 cd/m² [V]** | **CIE x/y** |
|---|---|---|---|---|
| Bsp. 7 (Vergleich) | M1 (20 %) | 4,3 | 8,4 | 0,45 / 0,49 |
| | M3 (70 %) | | | |
| | Emitter E1 | | | |
| Bsp. 8 | M1 (65 %) | 5,7 | 5,6 | 0,12 / 0,26 |
| | M3 (25 %) | | | |
| | Bsp. 1 | | | |
| Bsp. 9 | M3 | 3,0 | 6,5 | 0,11 / 0,23 |
| | Bsp. 2 | | | |
| Bsp. 10 | M2 (55 %) | 3,5 | 6,3 | 0,12 / 0,25 |
| | M3 (35 %) | | | |
| | Bsp. 3 | | | |
| Bsp. 11 | M1 (20 %) | 9,3 | 4,8 | 0,46 / 0,52 |
| | M3 (70 %) | | | |
| | Bsp. 4 | | | |

## Patentansprüche

1. Elektronische Vorrichtung enthaltend eine neutrale Verbindung der Formel III, IV oder V 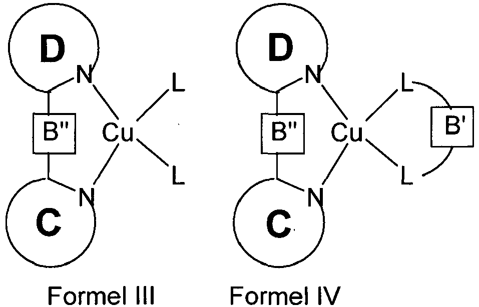 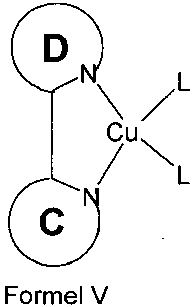
L ist ein einzähniger Phosphan- oder Arsan-Ligand R₃E (mit E = P oder As);
L-B'-L ist ein Phosphanyl- oder Arsanyl-Rest (R₂E#, mit E = P oder As), der über eine Brücke B' mit einem weiteren Rest L verbunden ist und damit einen zweizähnigen Liganden bildet;
B' ist eine Alkylen- oder Arylen-Gruppe oder einer Kombination beider, oder -O-, -NR- oder -SiR₂-;
und wobei die Stickstoffliganden die folgenden Formeln aufweisen: 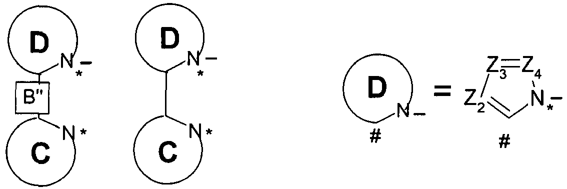 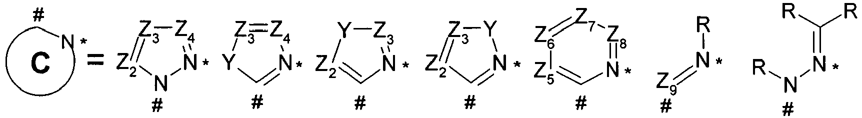 wobei * das Atom kennzeichnet, das die Komplexbindung eingeht und # das Atom kennzeichnet, das diretk oder über B" mit der zweiten Einheit verbunden ist, und für die weiteren verwendeten Symbole gilt:
Z₂ - Z₉ ist bei jedem Auftreten gleich oder verschieden N oder CR;
R ist bei jedem Auftreten gleich oder verschieden ausgewählt aus der Gruppe bestehend aus H, D, F, Cl, Br, I, CN, NO₂, N(R¹)₂, C(=O)R¹, Si(R¹)₃, einer geradkettigen Alkyl-, Alkoxy- oder Thioalkylgruppe mit 1 bis 40 C-Atomen oder einer verzweigten oder cyclischen Alkyl-, Alkoxy- oder Thioalkylgruppe mit 3 bis 40 C-Atomen oder einer Alkenyl- oder Alkinylgruppe mit 2 bis 40 C-Atomen, die jeweils mit einem oder mehreren Resten R¹ substituiert sein kann, wobei eine oder mehrere nicht-benachbarte CH₂-Gruppen durch R¹C=CR¹, C=C, Si(R¹)₂, Ge(R¹)₂, Sn(R¹)₂, C=O, C=S, C=Se, C=NR¹, P(=O)(R¹), SO, SO₂, NR¹, O, S oder CONR¹ ersetzt sein können und wobei ein oder mehrere H-Atome durch D, F, Cl, Br, I, CN oder NO₂ ersetzt sein können, einem aromatischen oder heteroaromatischen Ringsystem mit 5 bis 60 aromatischen Ringatomen, das jeweils mit einem oder mehreren Resten R¹ substituiert sein kann, einer Aryloxy- oder Heteroaryloxygruppe mit 5 bis 60 aromatischen Ringatomen, die mit einem oder mehreren Resten R¹ substituiert sein kann, oder einer Kombination dieser Systeme, wobei optional zwei oder mehr benachbarte Substituenten R ein monocyclisches oder polycyclisches, aliphatisches, aromatisches oder heteroaromatisches Ringsystem bilden können, das mit einem oder mehreren Resten R¹ substituiert sein kann;
R¹ ist bei jedem Auftreten gleich oder verschieden ausgewählt aus der Gruppe bestehend aus H, D, F, CN, aliphatischem Kohlenwasserstoffrest mit 1 bis 20 C-Atomen, aromatischem oder heteroaromatischem Ringsystem mit 5 bis 30 aromatischen Ringatomen, in dem ein oder mehrere H-Atome durch D, F, Cl, Br, I oder CN ersetzt sein können, wobei zwei oder mehr benachbarte Substituenten R³ miteinander ein mono- oder polycyclisches, aliphatisches, aromatisches oder hetero-aromatisches Ringsystem bilden können;
Y ist bei jedem Auftreten gleich oder verschieden O, S oder NR;
B" ist bei jedem Auftreten gleich oder verschieden eine bivalente Brücke, ausgewählt aus NR, BR, O, CR₂, SiR₂, C=NR, C=CR₂, S, S=O, SO₂, PR und P(=O)R.

2. Vorrichtung nach Ansprüche 1, **dadurch gekennzeichnet, dass** das koordinierende Atom E in den Liganden L gleich Phosphor ist.

3. Elektronische nach Anspruch 1 oder 2, **dadurch gekennzeichnet, dass** die Vorrichtung ausgewählt ist aus der Gruppe bestehend aus organischen Elektrolumineszenzvorrichtungen (OLEDs), organischen integrierten Schaltungen (O-ICs), organischen Feld-Effekt-Transistoren (O-FETs), organischen Dünnfilmtransistoren (O-TFTs), organischen lichtemittierenden Transistoren (O-LETs), organischen Solarzellen (O-SCs), organischen optischen Detektoren, organischen Photorezeptoren, organischen Feld-Quench-Devices (O-FQDs), lichtemittierenden elektrochemischen Zellen (LECs), organischen Laserdioden (O-Laser), OLED-Sensoren, insbesondere nicht hermetisch nach außen abgeschirmte Gas- und Dampf-Sensoren, und "organic plasmon emitting devices" enthaltend eine oder mehrere der Verbindungen der Formeln (III), (IV) und (V).

4. Vorrichtung nach Anspruch 3, **dadurch gekennzeichnet, dass** die Verbindung der Formeln (III), (IV) und (V) als Emitter in einer Emitterschicht eines lichtemittierenden optoelektronischen Bauelements oder als Absorbermaterialien in einer Absorberschicht eines optoelektronischen Bauelements oder als Ladungstransportmaterial, insbesondere als Lochtransportmaterial eingesetzt werden.

5. Organische Elektrolumineszenzvorrichtung nach Anspruch 3 oder 4, **dadurch gekennzeichnet, dass** die Verbindung der Formeln (III), (IV) und (V) in Kombination mit einem Matrixmaterial eingesetzt wird, wobei das Matrixmaterial bevorzugt ausgewählt ist aus aromatischen Ketonen, aromatischen Phosphinoxiden, aromatischen Sulfoxiden, aromatischen Sulfonen, Triarylaminen, Carbazolderivaten, Indolocarbazolderivaten, Azacarbazolderivaten, bipolaren Matrixmaterialien, Silanen, Azaborolen, Boronestern, Triazinderivaten, Zinkkomplexen, Diazasilol- bzw. Tetraazasilol-Derivaten oder Mischungen aus zwei oder mehr dieser Matrixmaterialien.

6. Verfahren zur Herstellung einer elektronischen Vorrichtung nach einem oder mehreren der Ansprüche 1 bis , **dadurch gekennzeichnet, dass** eine oder mehrere Schichten mit einem Sublimationsverfahren beschichtet werden oder dass eine oder mehrere Schichten mit dem OVPD (Organic Vapour Phase Deposition) Verfahren oder mit Hilfe einer Trägergassublimation beschichtet werden oder dass eine oder mehrere Schichten aus Lösung oder mit einem beliebigen Druckverfahren hergestellt werden.

## Claims

1. Electronic device containing a neutral compound of the formula III, IV or V 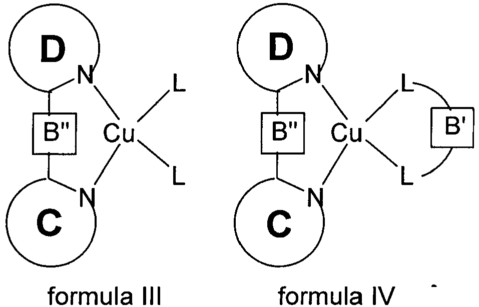 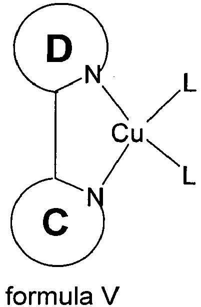 In which
L is a monodentate phosphine or arsine ligand R₃E (where E = P or As);
L-B'-L is a phosphanyl or arsanyl radical (R₂E#, where E = P or As), which is bonded to a further radical L via a bridge B' and thus forms a bidentate ligand;
B' is an alkylene or arylene group or a combination of the two, or -O-, -NR- or -SiR₂-;
and where the nitrogen ligands have the following formulae: 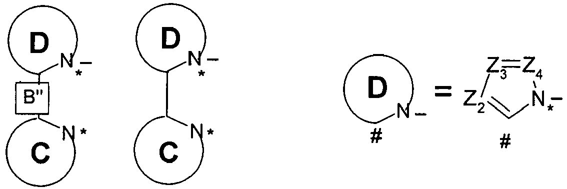 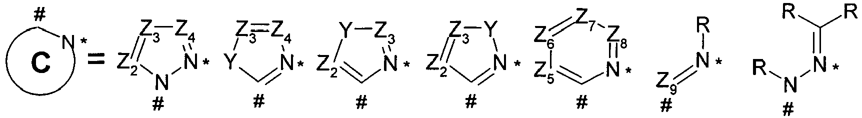 where * denotes the atom which enters the complex bonding and # denotes the atom which is bonded to the second unit directly or via B", and the following applies to the other symbols used:
Z₂ - Z₉ are on each occurrence, identically or differently, N or CR;
R is selected on each occurrence, identically or differently, from the group consisting of H, D, F, Cl, Br, I, CN, NO₂, N(R¹)₂, C(=O)R¹, Si(R¹)₃, a straight-chain alkyl, alkoxy or thioalkyl group having 1 to 40 C atoms or a branched or cyclic alkyl, alkoxy or thioalkyl group having 3 to 40 C atoms or an alkenyl or alkynyl group having 2 to 40 C atoms, each of which may be substituted by one or more radicals R¹, where one or more non-adjacent CH₂ groups may be replaced by R¹C=CR¹, C=C, Si(R¹)₂, Ge(R¹)₂, Sn(R¹)₂, C=O, C=S, C=Se, C=NR¹, P(=O)(R¹), SO, SO₂, NR¹, O, S or CONR¹ and where one or more H atoms may be replaced by D, F, Cl, Br, I, CN or NO₂, an aromatic or heteroaromatic ring system having 5 to 60 aromatic ring atoms, which may in each case be substituted by one or more radicals R¹, an aryloxy or heteroaryloxy group having 5 to 60 aromatic ring atoms, which may be substituted by one or more radicals R¹, or a combination of these systems, where two or more adjacent substituents R may optionally form a monocyclic or polycyclic, aliphatic, aromatic or heteroaromatic ring system, which may be substituted by one or more radicals R¹;
R¹ is selected on each occurrence, identically or differently, from the group consisting of H, D, F, CN, an aliphatic hydrocarbon radical having 1 to 20 C atoms, an aromatic or heteroaromatic ring system having 5 to 30 aromatic ring atoms, in which one or more H atoms may be replaced by D, F, Cl, Br, I or CN, where two or more adjacent substituents R³ may form a mono- or polycyclic, aliphatic, aromatic or heteroaromatic ring system with one another;
Y is on each occurrence, identically or differently, 0, S or NR;
B" is on each occurrence, identically or differently, a divalent bridge, selected from NR, BR, O, CR₂, SiR₂, C=NR, C=CR₂, S, S=O, SO₂, PR and P(=O)R.

2. Device according to Claim 1, **characterised in that** the coordinating atom E in the ligands L is equal to phosphorus.

3. Electronic device according to Claim 1 or 2, **characterised in that** the device is selected from the group consisting of organic electroluminescent devices (OLEDs), organic integrated circuits (O-ICs), organic field-effect transistors (O-FETs), organic thin-film transistors (O-TFTs), organic light-emitting transistors (O-LETs), organic solar cells (O-SCs), organic optical detectors, organic photoreceptors, organic field-quench devices (O-FQDs), light-emitting electrochemical cells (LECs), organic laser diodes (O-lasers), OLED sensors, in particular gas and vapour sensors which are not hermetically sealed against the outside, and organic plasmon emitting devices, containing one or more of the compounds of the formulae (III), (IV) and (V).

4. Device according to Claim 3, **characterised in that** the compound of the formulae (III), (IV) and (V) is employed as emitter in an emitter layer of a light-emitting opto-electronic component or as absorber material in an absorber layer of an opto-electronic component or as charge-transport material, in particular as hole-transport material.

5. Organic electroluminescent device according to Claim 3 or 4, **characterised in that** the compound of the formulae (III), (IV) and (V) is employed in combination with a matrix material, where the matrix material is preferably selected from aromatic ketones, aromatic phosphine oxides, aromatic sulfoxides, aromatic sulfones, triarylamines, carbazole derivatives, indolocarbazole derivatives, azacarbazole derivatives, bipolar matrix materials, silanes, azaboroles, boronic esters, triazine derivatives, zinc complexes, diazasilole or tetraazasilole derivatives or mixtures of two or more of these matrix materials.

6. Process for the production of an electronic device according to one or more of Claims 1 to 5, **characterised in that** one or more layers are applied by means of a sublimation process or **in that** one or more layers are applied by means of the OVPD (organic vapour phase deposition) process or with the aid of carrier-gas sublimation or **in that** one or more layers are produced from solution or by means of any desired printing process.

## Revendications

1. Dispositif électronique contenant un composé neutre de la formule III, IV ou V: 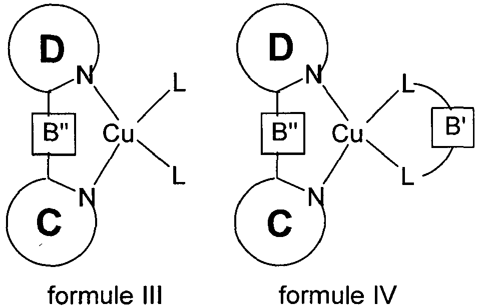 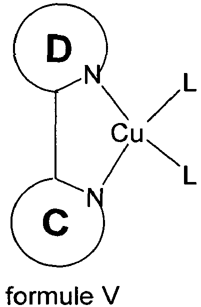 dans lesquelles :
L est un ligand phosphine ou arsine monodenté R₃E (où E = P ou As) ;
L-B'-L est un radical phosphanyle ou arsanyle (R₂E#, où E = P ou As), lequel est lié à un autre radical L via un pont B' et forme ainsi un ligand bidenté ;
B' est un groupe alkylène ou arylène ou une combinaison des deux, ou -O-, -NR- ou -SiR₂- ;
et où les ligands azote présentent les formules qui suivent : 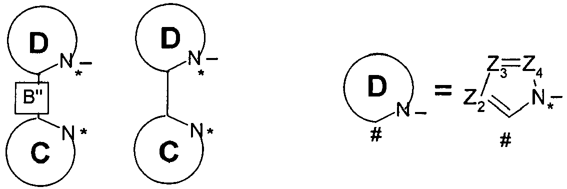 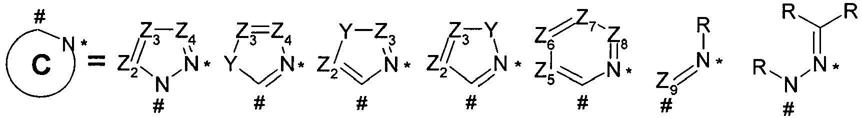 où * représente l'atome qui participe à la liaison complexe et # représente l'atome qui est lié à la seconde unité directement ou via B", et ce qui suit s'applique aux autres symboles utilisés :
Z₂ - Z₉ sont, pour chaque occurrence de manière identique ou différente, N ou CR ;
R est choisi, pour chaque occurrence de manière identique ou différente, parmi le groupe constitué par H, D, F, Cl, Br, I, CN, NO₂, N(R¹)₂, C(=O)R¹, Si(R¹)₃, un groupe alkyle, alcoxy ou thioalkyle en chaîne droite comportant de 1 à 40 atome(s) de C ou un groupe alkyle, alcoxy ou thioalkyle ramifié ou cyclique comportant de 3 à 40 atomes de C ou un groupe alkényle ou alkynyle comportant de 2 à 40 atomes de C, dont chacun peut être substitué par un radical ou plusieurs radicaux R¹, où un groupe ou plusieurs groupes CH₂ non adjacents peut/peuvent être remplacé(s) par R¹C=CR¹, C≡C, Si(R¹)₂, Ge(R¹)₂, Sn(R¹)₂, C=O, C=S, C=Se, C=NR¹, P(=O)(R¹), SO, SO₂, NR¹, O, S ou CONR¹ et où un ou plusieurs atome(s) de H peut/peuvent être remplacé(s) par D, F, Cl, Br, I, CN ou NO₂, un système de cycle aromatique ou hétéroaromatique comportant de 5 à 60 atomes de cycle aromatique, lequel peut dans chaque cas être substitué par un radical ou plusieurs radicaux R¹, un groupe aryloxy ou hétéroaryloxy comportant de 5 à 60 atomes de cycle aromatique, lequel peut être substitué par un radical ou plusieurs radicaux R¹, ou une combinaison de ces systèmes, où deux substituants R adjacents ou plus peuvent en option former un système de cycle aliphatique, aromatique ou hétéroaromatique monocyclique ou polycyclique, lequel peut être substitué par un radical ou plusieurs radicaux R¹ ;
R¹ est choisi, pour chaque occurrence de manière identique ou différente, parmi le groupe constitué par H, D, F, CN, un radical hydrocarbone aliphatique comportant de 1 à 20 atome(s) de C, un système de cycle aromatique ou hétéroaromatique comportant de 5 à 30 atomes de cycle aromatique, où un ou plusieurs atome(s) de H peut/peuvent être remplacé(s) par D, F, CI, Br, I ou CN, où deux substituants R³ adjacents ou plus peuvent former un système de cycle aliphatique, aromatique ou hétéroaromatique monocyclique ou polycyclique l'un avec l'autre ou les uns avec les autres ;
Y est, pour chaque occurrence de manière identique ou différente, O, S ou NR ;
B" est pour chaque occurrence, de manière identique ou différente, un pont divalent, choisi parmi NR, BR, O, CR₂, SiR₂, C=NR, C=CR₂, S, S=O, SO₂, PR et P(=O)R.

2. Dispositif selon la revendication 1, **caractérisé en ce que** l'atome de coordination E dans les ligands L est égal à phosphore.

3. Dispositif électronique selon la revendication 1 ou 2, **caractérisé en ce que** le dispositif est choisi parmi le groupe constitué par des dispositifs électroluminescents organiques (OLED), des circuits intégrés organiques (O-IC), des transistors à effet de champ organiques (O-FET), des transistors à film mince organiques (O-TFT), des transistors émetteurs de lumière organiques (O-LET), des cellules solaires organiques (O-SC), des détecteurs optiques organiques, des photorécepteurs organiques, des dispositifs à extinction de champ organiques (O-FQD), des cellules électrochimiques émettrices de lumière (LEC), des diodes laser organiques (O-laser), des capteurs OLED, en particulier des capteurs de gaz et de vapeur qui ne sont pas hermétiquement protégés vis-à-vis de l'extérieur, et des dispositifs émetteurs de plasmons organiques contenant un ou plusieurs des composés des formules (III), (IV) et (V).

4. Dispositif selon la revendication 3, **caractérisé en ce que** le composé des formules (III), (IV) et (V) est utilisé en tant qu'émetteur dans une couche d'émetteur d'un composant optoélectronique émetteur de lumière ou en tant que matériau d'absorbeur dans une couche d'absorbeur d'un composant optoélectronique ou en tant que matériau de transport de charges, en particulier en tant que matériau de transport de trous.

5. Dispositif électroluminescent organique selon la revendication 3 ou 4, **caractérisé en ce que** le composé des formules (III), (IV) et (V) est utilisé en combinaison avec un matériau de matrice, où le matériau de matrice est de préférence choisi parmi des cétones aromatiques, des oxydes de phosphine aromatiques, des sulfoxydes aromatiques, des sulfones aromatiques, des triarylamines, des dérivés de carbazole, des dérivés d'indolocarbazole, des dérivés d'azacarbazole, des matériaux de matrice bipolaires, des silanes, des azaboroles, des esters boroniques, des dérivés de triazine, des complexes de zinc, des dérivés de diazasilole ou de tétraazasilole ou des mélanges de deux de ces matériaux de matrice ou plus.

6. Procédé pour la production d'un dispositif électronique selon une ou plusieurs des revendications 1 à 5, **caractérisé en ce qu'**une couche ou plusieurs couches est/sont appliquée(s) au moyen d'un procédé de sublimation ou **en ce qu'**une couche ou plusieurs couches est/sont appliquée(s) au moyen du procédé OVPD (dépôt organique en phase vapeur) ou à l'aide d'une sublimation par gaz porteur ou **en ce qu'**une couche ou plusieurs couches est/sont produite(s) à partir d'une solution ou au moyen de n'importe quel procédé d'impression souhaité.
